(19) Europäisches Patentamt
European Patent Office
Office européen des brevets

(11) **EP 3 540 777 A1**

(12) **EUROPEAN PATENT APPLICATION**

(43) Date of publication:
**18.09.2019 Bulletin 2019/38**

(51) Int Cl.:
*H01L 27/15* (2006.01)    *B41J 2/45* (2006.01)
*H01L 29/74* (2006.01)

(21) Application number: **18213517.8**

(22) Date of filing: **18.12.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.12.2017   JP 2017242709**

(71) Applicant: **Oki Data Corporation Tokyo 108 (JP)**

(72) Inventors:
• **TANIGAWA, Kenichi** **Tokyo, 108-8551 (JP)**
• **KAWADA, Hiroto** **Tokyo, 108-8551 (JP)**

(74) Representative: **Piotrowicz, Pawel Jan Andrzej et al** **Venner Shipley LLP** **Byron House** **Cambridge Business Park** **Cowley Road** **Cambridge CB4 0WZ (GB)**

(54) **SEMICONDUCTOR DEVICE, LIGHT-EMITTING DEVICE CHIP, OPTICAL PRINT HEAD, AND IMAGE FORMING DEVICE**

(57) A semiconductor device 1000 includes a light-emitting thyristor 10, including a first semiconductor layer 1040 of a first conductivity type, a second semiconductor layer 1030 of a second conductivity type, a third semiconductor layer 1020 of the first conductivity type, and a fourth semiconductor layer 1010 of the second conductivity type, and first to third electrodes 61A, 51G and 41K. The first semiconductor layer 1040 includes a first layer 1043, a second layer 1042 having a band gap BGcl1 wider than band gaps BGng and BGpg of the second semiconductor layer 1030 and the third semiconductor layer 1020, and a third layer 1041 having an impurity concentration IMac1 higher than impurity concentrations IMng and IMpg of the second semiconductor layer 1030 and the third semiconductor layer 1020 and having a band gap BGac1 narrower than or equal to the band gaps BGng and BGpg of the second semiconductor layer 1030 and the third semiconductor layer 1020.

FIG. 2

EP 3 540 777 A1

**Description**

**BACKGROUND OF THE INVENTION**

**1. Field of the Invention**

The present invention relates to a semiconductor device including a light-emitting thyristor, a light-emitting device chip including the semiconductor device arranged on a substrate part, an optical print head including the light-emitting device chip, and an image forming device including the optical print head.

**2. Description of the Related Art**

Conventionally, image forming devices for forming an image on a print medium by means of an electrophotographic process are widespread. In the image forming device, an electrostatic latent image is formed on the surface of a photosensitive drum by irradiating the surface with light emitted from an optical print head including a plurality of light-emitting devices arranged in a line, a developing agent image is formed by developing the electrostatic latent image, and the developing agent image is transferred onto a print medium and fixed. As the light-emitting devices included in the optical print head, light-emitting thyristors as three-terminal light-emitting devices are well known (see Japanese Patent Application Publication No. 2010-239084, for example).

However, a more excellent light emission property is being required of the conventional light-emitting thyristors.

**SUMMARY OF THE INVENTION**

The object of the present invention is to provide a semiconductor device including a light-emitting thyristor having an excellent light emission property, a light-emitting device chip including the semiconductor device arranged on a substrate part, an optical print head including the light-emitting device chip, and an image forming device including the optical print head.

A semiconductor device according to an aspect of the present invention includes:

a light-emitting thyristor including a first semiconductor layer of a first conductivity type, a second semiconductor layer of a second conductivity type arranged adjacent to the first semiconductor layer, a third semiconductor layer of the first conductivity type arranged adjacent to the second semiconductor layer, and a fourth semiconductor layer of the second conductivity type arranged adjacent to the third semiconductor layer;
a first electrode electrically connected with the first semiconductor layer;
a second electrode electrically connected with the second semiconductor layer or the third semiconductor layer; and
a third electrode electrically connected with the fourth semiconductor layer.

The first semiconductor layer includes:

a first layer electrically connected with the first electrode;
a second layer having a first band gap wider than a second band gap of the second semiconductor layer and a third band gap of the third semiconductor layer; and
a third layer having a first impurity concentration higher than a second impurity concentration of the second semiconductor layer and a third impurity concentration of the third semiconductor layer, the third layer having a fourth band gap narrower than or equal to the second band gap of the second semiconductor layer and the third band gap of the third semiconductor layer.

According to the present invention, a semiconductor device and a light-emitting device chip including a light-emitting thyristor having an excellent light emission property can be provided. Further, the quality of printed images can be improved in an image forming device employing an optical print head including such a light-emitting device chip.

**BRIEF DESCRIPTION OF THE DRAWINGS**

In the attached drawings:

Fig. 1 is a schematic plan view showing the structure of a semiconductor device in a first embodiment of the present invention;
Fig. 2 is a schematic cross-sectional view showing the structure of the semiconductor device in the first embodiment, namely, cross-sectional structure at sections of Fig. 1 along the line A-B-C viewed in the directions of arrows in Fig. 1;

Fig. 3 is a diagram showing an example of an impurity concentration and an Al composition ratio of each semiconductor layer in a light-emitting thyristor of the semiconductor device in Fig. 2;

Fig. 4 is a schematic cross-sectional view showing the structure of a semiconductor device of a first modification of the first embodiment;

Fig. 5 is a schematic cross-sectional view showing the structure of a semiconductor device of a second modification of the first embodiment;

Fig. 6 is a diagram showing an example of the impurity concentration and the Al composition ratio of each semiconductor layer in a light-emitting thyristor of the semiconductor device in Fig. 5;

Fig. 7 is a schematic cross-sectional view showing the structure of a semiconductor device of a third modification of the first embodiment;

Fig. 8 is a diagram showing an example of the impurity concentration and the Al composition ratio of each semiconductor layer in a light-emitting thyristor of the semiconductor device in Fig. 7;

Fig. 9 is a schematic cross-sectional view showing the structure of a semiconductor device of a fourth modification of the first embodiment;

Fig. 10 is a schematic cross-sectional view showing the structure of a semiconductor device in a second embodiment of the present invention;

Fig. 11 is a diagram showing an example of the impurity concentration and the Al composition ratio of each semiconductor layer in a light-emitting thyristor of the semiconductor device in Fig. 10;

Fig. 12 is a schematic cross-sectional view showing the structure of a semiconductor device of a first modification of the second embodiment;

Fig. 13 is a schematic cross-sectional view showing the structure of a semiconductor device of a second modification of the second embodiment;

Fig. 14 is a diagram showing an example of the impurity concentration and the Al composition ratio of each semiconductor layer in a light-emitting thyristor of the semiconductor device in Fig. 13;

Fig. 15 is a schematic cross-sectional view showing the structure of a semiconductor device of a third modification of the second embodiment;

Fig. 16 is a diagram showing an example of the impurity concentration and the Al composition ratio of each semiconductor layer in a light-emitting thyristor of the semiconductor device in Fig. 15;

Fig. 17 is a schematic cross-sectional view showing the structure of a semiconductor device of a fourth modification of the second embodiment;

Fig. 18 is a schematic cross-sectional view showing the structure of a semiconductor device in a third embodiment of the present invention;

Fig. 19 is a diagram showing an example of the impurity concentration and the Al composition ratio of each semiconductor layer in a light-emitting thyristor of the semiconductor device in Fig. 18;

Fig. 20 is a schematic cross-sectional view showing the structure of a semiconductor device of a first modification of the third embodiment;

Fig. 21 is a schematic cross-sectional view showing the structure of a semiconductor device of a second modification of the third embodiment;

Fig. 22 is a diagram showing an example of the impurity concentration and the Al composition ratio of each semiconductor layer in a light-emitting thyristor of the semiconductor device in Fig. 21;

Fig. 23 is a schematic cross-sectional view showing the structure of a semiconductor device of a third modification of the third embodiment;

Fig. 24 is a diagram showing an example of the impurity concentration and the Al composition ratio of each semiconductor layer in a light-emitting thyristor of the semiconductor device in Fig. 23;

Fig. 25 is a schematic cross-sectional view showing the structure of a semiconductor device of a fourth modification of the third embodiment;

Fig. 26 is a schematic perspective view showing the structure of a substrate unit as a principal part of an optical print head in a fourth embodiment of the present invention;

Fig. 27 is a schematic cross-sectional view showing the structure of the optical print head in the fourth embodiment; and

Fig. 28 is a schematic cross-sectional view showing the structure of an image forming device in a fifth embodiment of the present invention.

## DETAILED DESCRIPTION OF THE INVENTION

Semiconductor devices, light-emitting device chips, an optical print head and an image forming device according to embodiments of the present invention will be described below with reference to the accompanying drawings. In the drawings, the same components are assigned the same reference character. The following embodiments are just examples for the purpose of illustration and a variety of modifications are possible within the scope of the present invention.

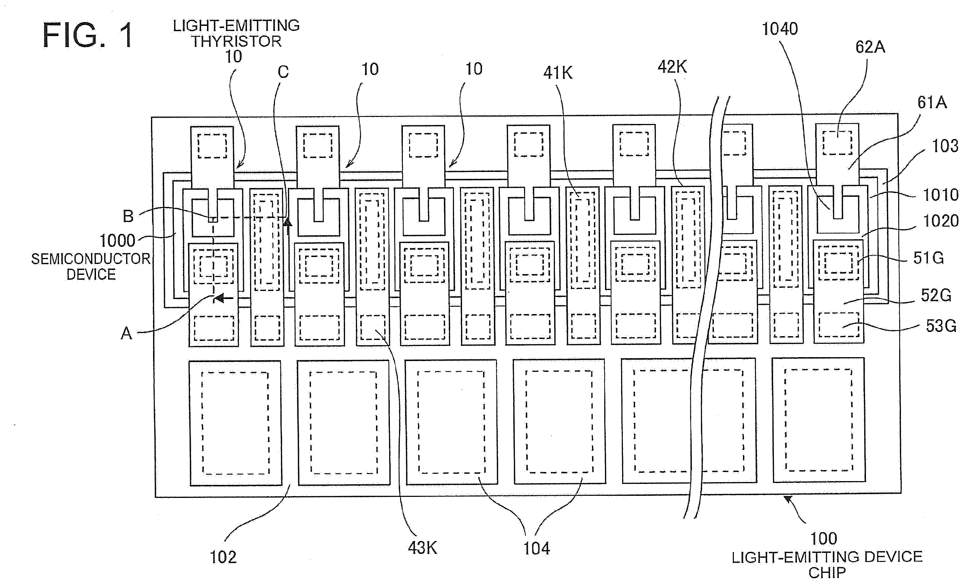

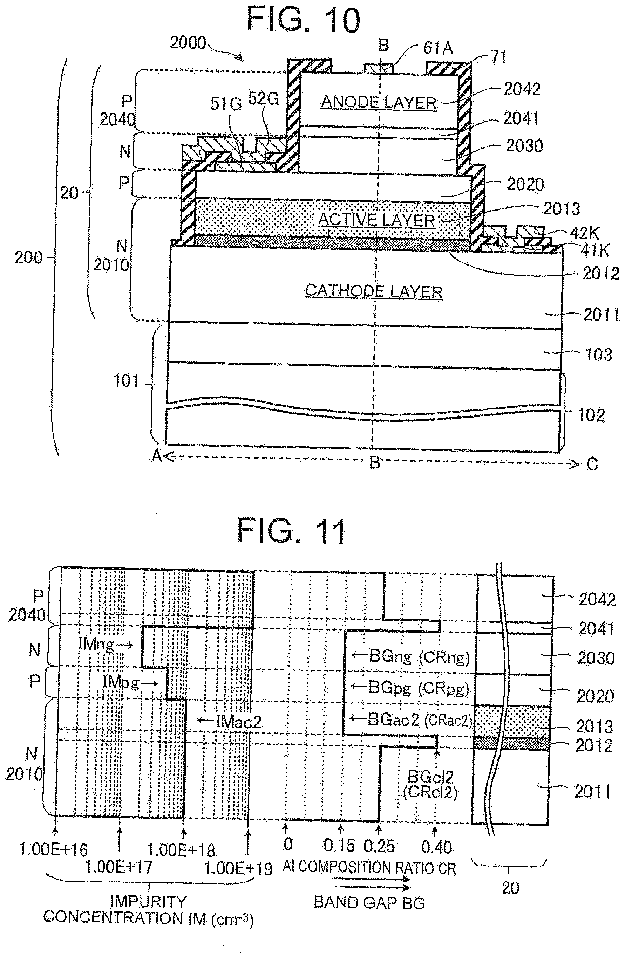

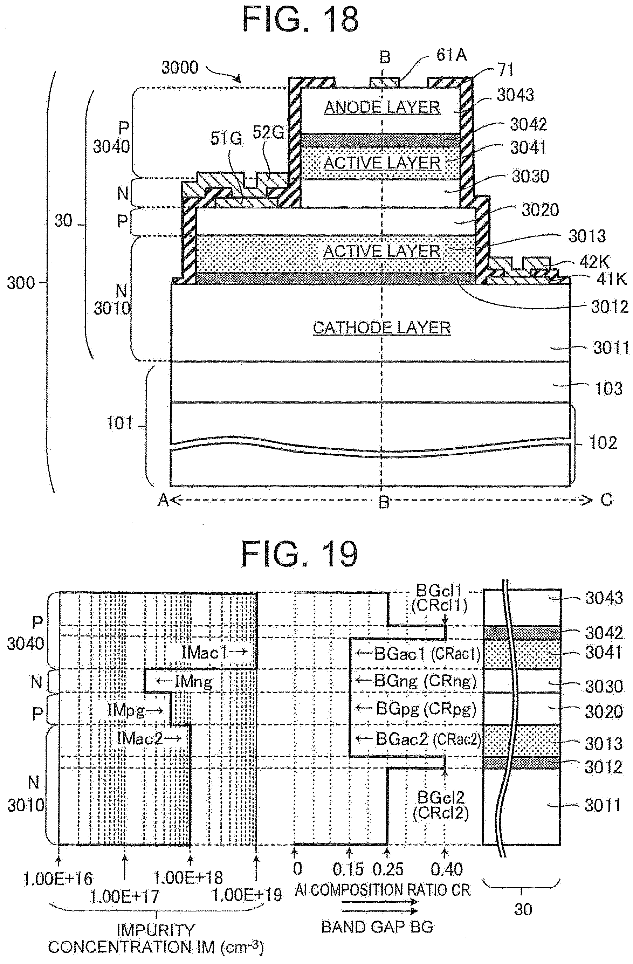

In a first embodiment (Fig. 1 to Fig. 9), a second embodiment (Fig. 10 to Fig. 17) and a third embodiment (Fig. 18 to Fig. 25), the semiconductor devices and the light-emitting device chips will be described. The semiconductor device includes one or more light-emitting thyristors. The semiconductor device may include a plurality of light-emitting thyristors arranged in a line. The light-emitting device chip includes a substrate part and the semiconductor device arranged on the substrate part. The light-emitting device chip may include a semiconductor integrated circuit part (referred to also as a "drive IC part") as a drive circuit for lighting up and extinguishing the light-emitting thyristors of the semiconductor device. The light-emitting device chip including the semiconductor device and the drive IC part is referred to also as a "semiconductor composite device".

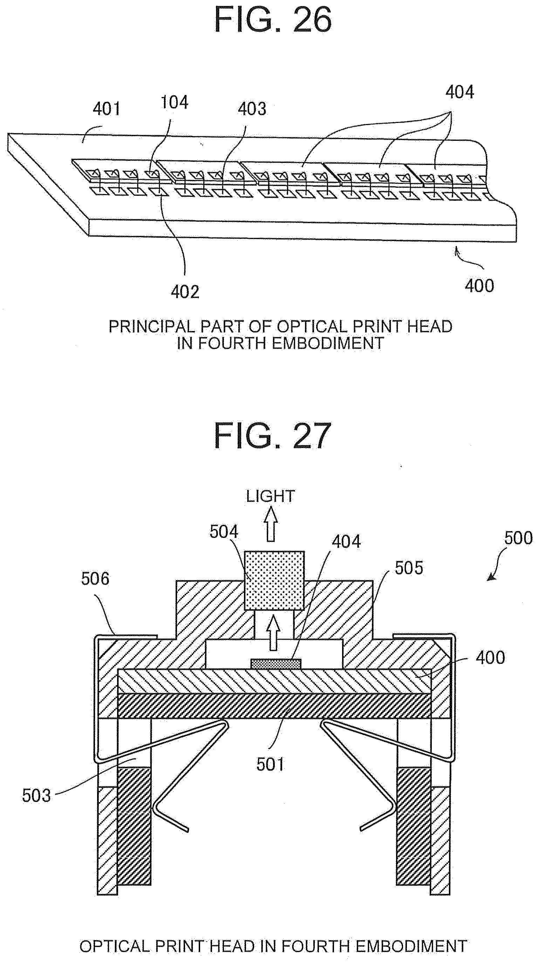

In a fourth embodiment (Fig. 26 to Fig. 27), the optical print head including the light-emitting device chip in any one of the first to third embodiments will be described. The optical print head includes one or more light-emitting device chips. The optical print head is an exposure device as an electrostatic latent image formation means in an image forming device that forms an image made of a developing agent on a print medium by means of an electrophotographic process. The optical print head may include a plurality of light-emitting device chips arranged in a line.

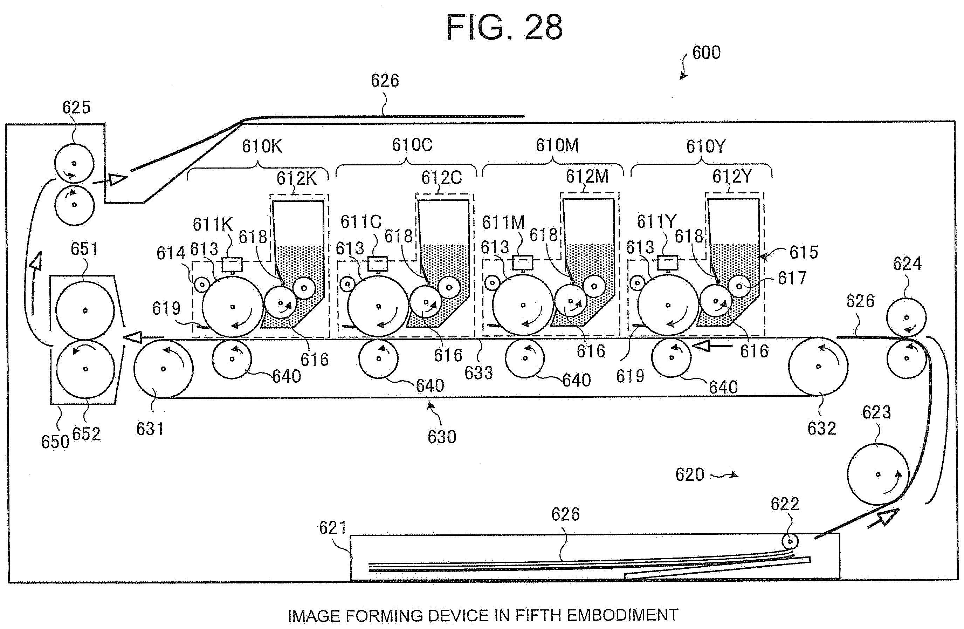

In a fifth embodiment (Fig. 28), the image forming device including the optical print head in the fourth embodiment will be described. The image forming device is a device for forming an image made of a developing agent on a print medium by means of the electrophotographic process, such as a printer, a copy machine, a facsimile machine, a multi-function peripheral (MFP) or the like, for example.

(1) First Embodiment

(1-1) Configuration

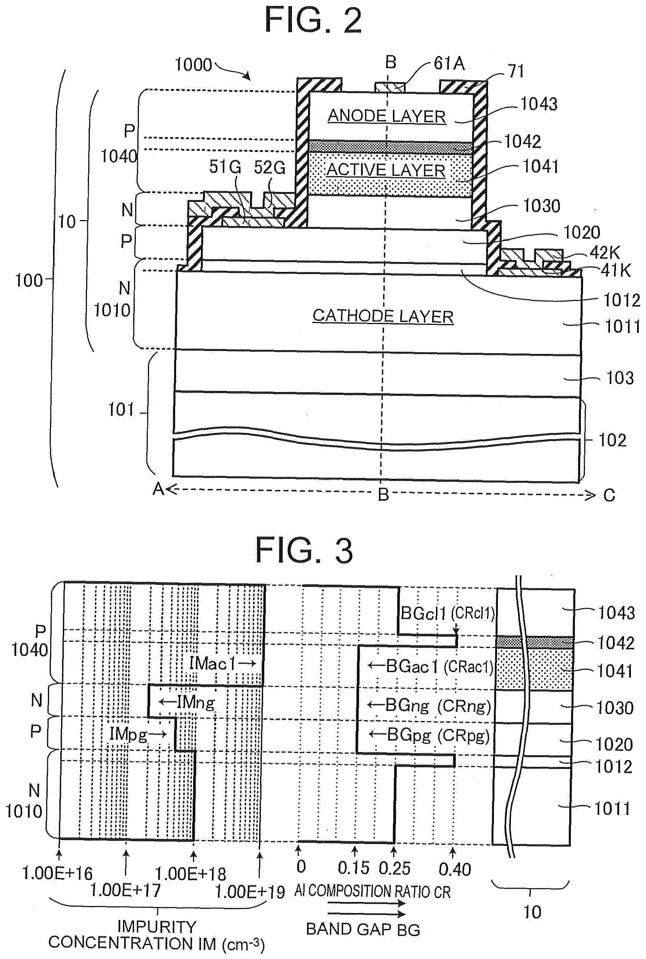

Fig. 1 is a schematic plan view showing the structure of a semiconductor device 1000 in the first embodiment. Fig. 2 is a schematic cross-sectional view showing the structure of the semiconductor device 1000 in the first embodiment, namely, cross-sectional structure at sections of Fig. 1 along the line A-B-C viewed in the directions of arrows in Fig. 1. The semiconductor device 1000 in the first embodiment is arranged on a substrate part 101. The substrate part 101 includes, for example, a substrate 102 and a planarization layer 103 formed on the substrate 102 as shown in Fig. 2. A light-emitting device chip 100 includes the substrate part 101 and the semiconductor device 1000 arranged on the substrate part 101.

For example, a Si (silicon) substrate, an IC (integrated circuit) substrate, a glass substrate, a ceramic substrate, a plastic substrate, a metal substrate or the like is usable as the substrate 102. In the first embodiment, the substrate 102 is an IC substrate including the drive IC part for driving the light-emitting thyristors as the three-terminal light-emitting devices and an external connection pad 104 used for wiring to an external device.

The planarization layer 103 has a smooth surface on which the semiconductor device 1000 is arranged. The planarization layer 103 is an inorganic film or an organic film. In a case where a top surface of the substrate 102 is smooth, it is also possible to provide the semiconductor device 1000 on the top surface of the substrate 102 without providing the planarization layer 103.

As shown in Fig. 1, the semiconductor device 1000 includes a plurality of light-emitting thyristors 10 arranged in a line. The semiconductor device 1000 is referred to also as a "light-emitting device array" or a "light-emitting thyristor array". Further, the light-emitting device chip 100 is referred to also as a "light-emitting device array chip" or a "light-emitting thyristor array chip". Incidentally, an insulation film 71 (shown in Fig. 2) is not shown in Fig. 1 for easy understanding of the structure of the semiconductor device 1000.

The light-emitting thyristor 10 is formed on a growth substrate as a manufacturing substrate, for example. In a case where the light-emitting thyristor 10 is formed of an AlGaAs (aluminum gallium arsenide)-based semiconductor material, a GaAs (gallium arsenide) substrate can be used as the growth substrate. The light-emitting thyristor 10 is formed on the growth substrate by means of epitaxial growth, for example. The light-emitting thyristor 10 is formed by, for example, peeling off an epitaxial film, as a semiconductor thin film having a laminated structure of semiconductor layers, from the growth substrate, sticking the epitaxial film on the surface of the planarization layer 103 on the substrate 102, and processing the epitaxial film. The epitaxial film placed on the surface of the planarization layer 103 is fixed to the planarization layer 103 by intermolecular force or the like.

As shown in Fig. 1, the semiconductor device 1000 includes the plurality of light-emitting thyristors 10. As shown in Fig. 2, each light-emitting thyristor 10 includes a first semiconductor layer 1040 of a first conductivity type, a second semiconductor layer 1030 of a second conductivity type different from the first conductivity type arranged adjacent to the first semiconductor layer 1040, a third semiconductor layer 1020 of the first conductivity type arranged adjacent to the second semiconductor layer 1030, and a fourth semiconductor layer 1010 of the second conductivity type arranged adjacent to the third semiconductor layer 1020.

In the semiconductor device 1000, the first semiconductor layer 1040 of the first conductivity type is a P-type semiconductor layer, the second semiconductor layer 1030 of the second conductivity type is an N-type gate layer, the third semiconductor layer 1020 of the first conductivity type is a P-type gate layer, and the fourth semiconductor layer 1010 of the second conductivity type is an N-type semiconductor layer.

Further, as shown in Fig. 2, the semiconductor device 1000 includes an anode electrode 61A as a first electrode electrically connected with the first semiconductor layer 1040, a gate electrode 51G as a second electrode electrically connected with the third semiconductor layer (P-type gate layer) 1020, and a cathode electrode 41K as a third electrode electrically connected with the fourth semiconductor layer 1010. The anode electrode 61A is electrically connected with an anode terminal 62A (shown in Fig. 1) of the substrate part 101. The gate electrode 51G is electrically connected with a gate terminal 53G (shown in Fig. 1) of the substrate part 101 by gate wiring 52G. The cathode electrode 41K is connected with a cathode terminal 43K (shown in Fig. 1) of the substrate part 101 by cathode wiring 42K.

The P-type first semiconductor layer 1040 includes an anode layer 1043 as a first layer electrically connected with the anode electrode 61A, an electron cladding layer (barrier layer) 1042 as a second layer arranged adjacent to the anode layer 1043, and an active layer 1041 as a third layer arranged adjacent to the electron cladding layer 1042.

The N-type fourth semiconductor layer 1010 includes a cathode layer 1011 electrically connected with the cathode electrode 41K and a hole cladding layer 1012 arranged between the cathode layer 1011 and the third semiconductor layer (P-type gate layer) 1020.

Fig. 3 is a diagram showing an example of an impurity concentration IM ($cm^{-3}$) and an Al (aluminum) composition ratio CR of each semiconductor layer in the light-emitting thyristor 10 of the semiconductor device 1000.

In the first embodiment, let IMpg represent the impurity concentration of the third semiconductor layer (P-type gate layer) 1020, IMng represent the impurity concentration of the second semiconductor layer (N-type gate layer) 1030, and IMac1 represent the impurity concentration of the active layer (third layer) 1041 of the first semiconductor layer 1040, the light-emitting thyristor 10 is formed so as to satisfy the following conditional expressions (1) and (2):

$$\mathrm{IMpg} < \mathrm{IMac1} \qquad\qquad (1)$$

$$\mathrm{IMng} < \mathrm{IMac1} \qquad\qquad (2)$$

In Fig. 3, the following numerical examples are shown as the impurity concentrations:

$$\mathrm{IMac1} \approx 1 \times 10^{19} \ (cm^{-3})$$

$$\mathrm{IMpg} \approx 5 \times 10^{17} \ (cm^{-3})$$

$$\mathrm{IMng} \approx 2 \times 10^{17} \ (cm^{-3})$$

However, the impurity concentrations are not limited to the example of Fig. 3.

In the light-emitting thyristor 10, the reason for setting the impurity concentration IMpg of the third semiconductor layer (P-type gate layer) 1020 and the impurity concentration IMng of the second semiconductor layer (N-type gate layer) 1030 at low values and setting the impurity concentration IMac1 of the active layer 1041 of the first semiconductor layer 1040 at a high value is to increase the luminous efficiency by lowering the occurrence probability of recombination of an electron and a hole in the third semiconductor layer 1020 and the second semiconductor layer 1030 and raising the occurrence probability of the recombination of an electron and a hole in the active layer 1041.

Further, in the first embodiment, let CRpg represent the Al composition ratio of the third semiconductor layer (P-type gate layer) 1020, CRng represent the Al composition ratio of the second semiconductor layer (N-type gate layer) 1030, CRac1 represent the Al composition ratio of the active layer (third layer) 1041, and CRcl1 represent the Al composition ratio of the electron cladding layer (second layer) 1042, the light-emitting thyristor 10 is formed so as to satisfy the following conditional expression (3):

$$\mathrm{CRac1} = \mathrm{CRng} = \mathrm{CRpg} < \mathrm{CRcl1} \qquad\qquad (3)$$

However, CRac1 = CRng = CRpg in the expression (3) does not necessarily have to be satisfied. The light-emitting thyristor 10 may also be formed so as to satisfy the following conditional expressions (4) and (5) instead of the conditional expression (3) :

$$CRac1 \leq CRpg < CRcl1 \qquad (4)$$

$$CRac1 \leq CRng < CRcl1 \qquad (5)$$

The Al composition ratio CR of each semiconductor layer of the light-emitting thyristor 10 corresponds to a band gap BG of each semiconductor layer. Put another way, the band gap BG of each semiconductor layer of the light-emitting thyristor 10 increases with the increase in the Al composition ratio CR of the semiconductor layer, and the band gap BG of each semiconductor layer decreases with the decrease in the Al composition ratio CR of the semiconductor layer. Thus, the conditional expressions (3) to (5) are equivalent to the following conditional expressions (6) to (8) using the band gap:

$$BGac1 = BGng = BGpg < BGcl1 \qquad (6)$$

$$BGac1 \leq BGpg < BGcl1 \qquad (7)$$

$$BGac1 \leq BGng < BGcl1 \qquad (8)$$

where BGpg represents the band gap of the third semiconductor layer (P-type gate layer) 1020, BGng represents the band gap of the second semiconductor layer (N-type gate layer) 1030, BGac1 represents the band gap of the active layer 1041, and BGcl1 represents the band gap of the electron cladding layer 1042.

In Fig. 3, the following numerical examples are shown as the Al composition ratios:

$$CRac1 = CRng = CRpg \approx 0.15$$

$$CRcl1 \approx 0.40$$

However, the Al composition ratios are not limited to the example of Fig. 3.

The semiconductor materials forming the light-emitting thyristor 10 are, for example, InP (indium-phosphorous)-based semiconductor materials, AlGaAs-based semiconductor materials, AlInGaP (aluminum-indium-gallium-phosphorous)-based semiconductor materials, or the like.

In a case where the light-emitting thyristor 10 is formed with AlGaAs-based semiconductor materials, each semiconductor layer can be configured as below, for example. The cathode layer 1011 of the fourth semiconductor layer 1010 is formed with an N-type $Al_{0.25}Ga_{0.75}As$ layer, and the hole cladding layer 1012 of the fourth semiconductor layer 1010 is formed with an N-type $Al_{0.4}Ga_{0.6}As$ layer. The third semiconductor layer (P-type gate layer) 1020 is formed with a P-type $Al_{0.15}Ga_{0.85}As$ layer, and the second semiconductor layer (N-type gate layer) 1030 is formed with an N-type $Al_{0.15}Ga_{0.85}As$ layer. Further, in the first semiconductor layer 1040, the active layer 1041 is formed with a P-type $Al_{0.15}Ga_{0.85}As$ layer, the electron cladding layer 1042 is formed with a P-type $Al_{0.4}Ga_{0.6}As$ layer, and the anode layer 1043 is formed with a P-type $Al_{0.25}Ga_{0.75}As$ layer.

In a case where AlGaAs is expressed as $Al_yGa_{1-y}As$ ($0 \leq y \leq 1$), y is the Al composition ratio. The Al composition ratio CRcl1 of the electron cladding layer 1042 is desired to be within a range from 0.2 to 1.0. The electron cladding layer 1042 whose Al composition ratio CRcl1 is 1.0 is an AlAs layer since the composition ratio of Ga is 0.

Further, the Al composition ratio CRac1 of the active layer 1041 is desired to be within a range from 0.14 to 0.18, and the Al composition ratios CRng and CRpg of the second semiconductor layer (N-type gate layer) 1030 and the third semiconductor layer (P-type gate layer) 1020 are desired to be within a range from 0.14 to 0.3.

The gate electrode 51G and the anode electrode 61A can be formed with metal capable of forming an ohmic contact with P-type AlGaAs, such as Ti (titanium), Pt (platinum), Au (gold), Ni (nickel) or Zn (zinc), alloy of these metals, a laminated structure of these metals or alloys, or the like. The cathode electrode 41K can be formed with metal capable of forming an ohmic contact with N-type AlGaAs, such as Au, Ge (germanium), Ni or Pt, alloy of these metals, a laminated structure of these metals or alloys, or the like.

The insulation film 71 can be formed with an inorganic insulation film such as a SiN film (silicon nitride film) or a $SiO_2$ film (silicon dioxide film), or an organic insulation film such as a polyimide film.

(1-2) Operation

In the semiconductor device 1000, the drive IC part supplies gate current from the gate electrode 51G to the cathode electrode 41K, and thereby the light-emitting thyristor 10 is brought into a lighted state (light emission state), i.e., an on state. Further, the drive IC part lets current higher than or equal to a holding current flow between the anode electrode 61A and the cathode electrode 41K, and thereby the lighted state is maintained. In the first embodiment, the light emission from the light-emitting thyristor 10 is mainly caused by the recombination of a hole in the active layer 1041 and an electron moving from the second semiconductor layer (N-type gate layer) 1030 into the active layer 1041. Light generated by the recombination passes through the electron cladding layer 1042 and the anode layer 1043 and then exits upward (upward in Fig. 2) from the top surface of the anode layer 1043.

When the light-emitting thyristor 10 is in the lighted state, the recombination of an electron and a hole occurs also in the third semiconductor layer (P-type gate layer) 1020 and the second semiconductor layer (N-type gate layer) 1030. However, carrier mobility in the active layer 1041 is lower than that in the P-type and N-type gate layers since the impurity concentration IMac1 of the active layer 1041 is set higher than the impurity concentrations IMpg and IMng of the third semiconductor layer (P-type gate layer) 1020 and the second semiconductor layer (N-type gate layer) 1030 as indicated by the aforementioned conditional expressions (1) and (2). Thus, in the active layer 1041, the recombination occurs at an occurrence probability higher than occurrence probabilities of the recombination in the third semiconductor layer (P-type gate layer) 1020 and the second semiconductor layer (N-type gate layer) 1030. Namely, if the impurity concentration IMac1 of the active layer 1041 is set higher than the impurity concentrations IMpg and IMng of the third semiconductor layer (P-type gate layer) 1020 and the second semiconductor layer (N-type gate layer) 1030, the concentration of carries (holes in Fig. 2) in the active layer 1041 increases, and accordingly, the occurrence probability of the recombination of a hole and an electron increases.

Further, in a case where the band gap BGcl1 of the electron cladding layer 1042 is wider than the band gaps BGng and BGpg of the second semiconductor layer (N-type gate layer) 1030 and the third semiconductor layer (P-type gate layer) 1020 as indicated by the aforementioned conditional expression (6) or conditional expressions (7) and (8), electrons that have moved from the second semiconductor layer (N-type gate layer) 1030 to the active layer 1041 are received by the electron cladding layer 1042, by which the amount of electrons leaking from the electron cladding layer 1042 to the anode layer 1043 is reduced. Namely, since the electron cladding layer 1042 with the wide band gap has the function as a barrier layer limiting the passage of electrons, the leakage of the electrons to the anode layer 1043 that have moved from the second semiconductor layer (N-type gate layer) 1030 to the active layer 1041 is reduced. This will be referred to as an "electron confinement effect". Accordingly, the decrease in the amount of electrons in the active layer 1041 is inhibited and the occurrence probability of the recombination of a hole and an electron in the active layer 1041 increases.

(1-3) Effect

As described above, in the semiconductor device 1000, the electron confinement effect in the active layer 1041 is achieved by the electron cladding layer 1042 satisfying BGac1 < BGcl1 as indicated by the aforementioned conditional expression (6) or conditional expressions (7) and (8). With this electron confinement effect, the probability of the recombination of an electron heading from the cathode layer 1011 towards the anode layer 1043 with a hole in the active layer 1041 increases and the luminous efficiency rises, and accordingly, the amount of light emission increases.

Further, in the semiconductor device 1000, the impurity concentration IMpg of the third semiconductor layer (P-type gate layer) 1020 and the impurity concentration IMng of the second semiconductor layer (N-type gate layer) 1030 are set low and the impurity concentration IMac1 of the active layer 1041 is set high as indicated by the conditional expressions (1) and (2). Thus, the carrier mobility in the third semiconductor layer (P-type gate layer) 1020 and the second semiconductor layer (N-type gate layer) 1030 gets high and the occurrence probability of the recombination in the third semiconductor layer (P-type gate layer) 1020 and the second semiconductor layer (N-type gate layer) 1030 gets low. Meanwhile, the carrier mobility in the active layer 1041 gets low and the occurrence probability of the recombination in the active layer 1041 gets high. Therefore, the occurrence probability of the recombination of a hole and an electron in the active layer 1041 increases and the luminous efficiency rises, and accordingly, the amount of light emission increases.

Furthermore, in the semiconductor device 1000, the active layer 1041 is provided in an upper part (i.e., on a side farther from the substrate part 101) of the light-emitting thyristor 10 as a semiconductor laminated structure. Since the light generated in the active layer 1041 is extracted in the upward direction in Fig. 2 as above, absorption of the light generated in the active layer 1041 is reduced and light extraction efficiency is increased, and accordingly, the amount of light emission increases.

Ad described above, according to the semiconductor device 1000 and the light-emitting device chip 100 in the first embodiment, the amount of light emission increases in comparison with the conventional gate light emission type light-emitting thyristors.

(1-4) First Modification of First Embodiment

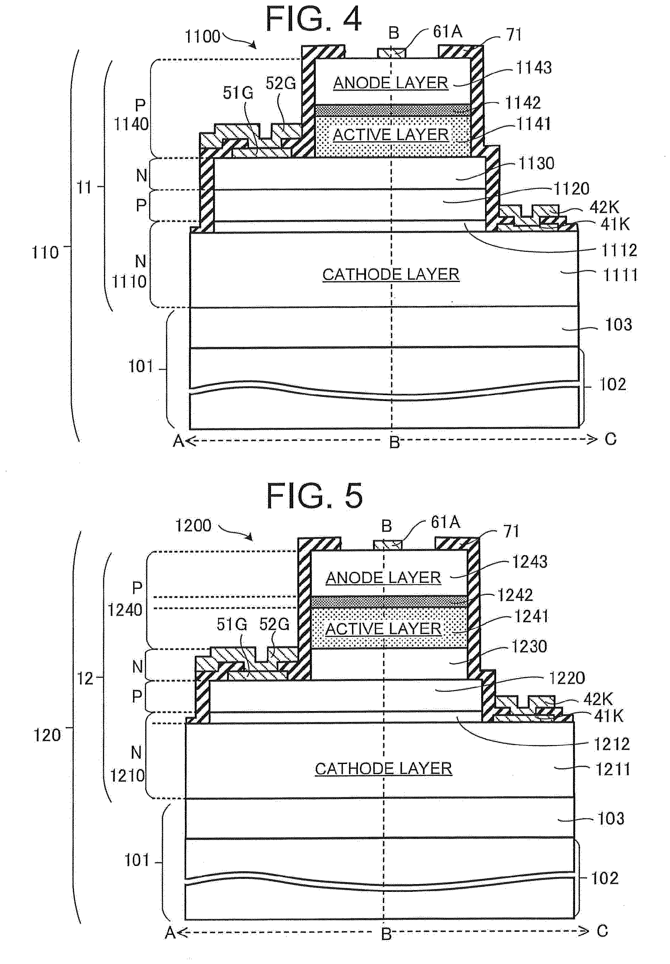

Fig. 4 is a schematic cross-sectional view showing the structure of a semiconductor device 1100 of a first modification of the first embodiment (i.e., cross-sectional structure corresponding to the sections of Fig. 1 along the line A-B-C). The semiconductor device 1100 differs from the semiconductor device 1000 shown in Fig. 2 in that a second semiconductor layer (N-type gate layer) 1130 is formed in a large region similar to a third semiconductor layer (P-type gate layer) 1120 (i.e., a large region including a formation region of a gate electrode 51G) and the gate electrode 51G is formed on the second semiconductor layer (N-type gate layer) 1130. Except this feature, the semiconductor device 1100 and a light-emitting device chip 110 in Fig. 4 are the same as the semiconductor device 1000 and the light-emitting device chip 100 in Fig. 2.

A light-emitting thyristor 11 of the semiconductor device 1100 in Fig. 4 includes a P-type first semiconductor layer 1140, the N-type second semiconductor layer (N-type gate layer) 1130, the P-type third semiconductor layer (P-type gate layer) 1120, and an N-type fourth semiconductor layer 1110. The first semiconductor layer 1140 includes an anode layer 1143 as a first layer, an electron cladding layer (barrier layer) 1142 as a second layer, and an active layer 1141 as a third layer. The fourth semiconductor layer 1110 includes a cathode layer 1111 and a hole cladding layer 1112. The first to fourth semiconductor layers 1140, 1130, 1120 and 1110 of the light-emitting thyristor 11 in Fig. 4 are formed with the same semiconductor materials as the first to fourth semiconductor layers 1040, 1030, 1020 and 1010 of the light-emitting thyristor. 10 in Fig. 2. Thus, the light-emitting thyristor 11 in Fig. 4 satisfies the aforementioned conditional expressions (1) to (8) similarly to the light-emitting thyristor 10 in Fig. 2. Accordingly, in the semiconductor device 1100 and the light-emitting device chip 110 in Fig. 4, the amount of light emission increases due to the rise in the luminous efficiency similarly to the case of the semiconductor device 1000 and the light-emitting device chip 100 in Fig. 2.

(1-5) Second Modification of First Embodiment

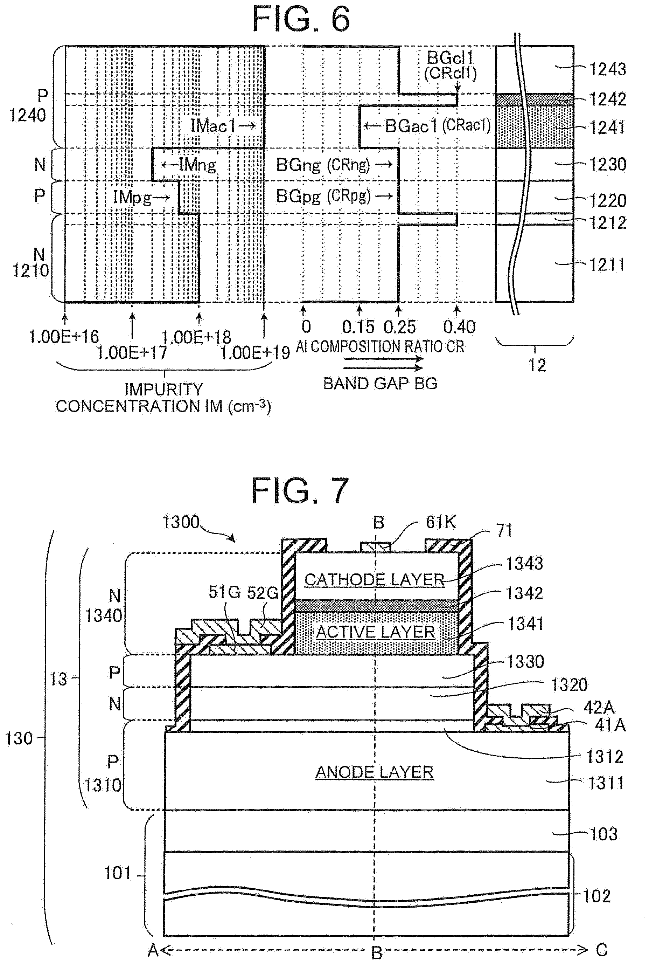

Fig. 5 is a schematic cross-sectional view showing the structure of a semiconductor device 1200 of a second modification of the first embodiment (i.e., cross-sectional structure corresponding to the sections of Fig. 1 along the line A-B-C). Fig. 6 is a diagram showing an example of the impurity concentration IM and the Al composition ratio CR of each semiconductor layer in a light-emitting thyristor 12 of the semiconductor device 1200 in Fig. 5. The semiconductor device 1200 differs from the semiconductor device 1000 shown in Fig. 2 in that the Al composition ratio CRng of a second semiconductor layer (N-type gate layer) 1230 and the Al composition ratio CRpg of a third semiconductor layer (P-type gate layer) 1220 are higher than the Al composition ratio CRac1 of an active layer 1241. Except this feature, the semiconductor device 1200 and a light-emitting device chip 120 in Fig. 5 are the same as the semiconductor device 1000 and the light-emitting device chip 100 in Fig. 2.

The light-emitting thyristor 12 of the semiconductor device 1200 in Fig. 5 includes a P-type first semiconductor layer 1240, the N-type second semiconductor layer (N-type gate layer) 1230, the P-type third semiconductor layer (P-type gate layer) 1220, and an N-type fourth semiconductor layer 1210. The first semiconductor layer 1240 includes an anode layer 1243 as a first layer, an electron cladding layer (barrier layer) 1242 as a second layer, and the active layer 1241 as a third layer. The fourth semiconductor layer 1210 includes a cathode layer 1211 and a hole cladding layer 1212. The first and fourth semiconductor layers 1240 and 1210 of the light-emitting thyristor 12 in Fig. 5 are formed with the same semiconductor materials as the first and fourth semiconductor layers 1040 and 1010 of the light-emitting thyristor 10 in Fig. 2. The second and third semiconductor layers 1230 and 1220 in Fig. 5 are the same as the second and third semiconductor layers 1030 and 1020 of the light-emitting thyristor 10 in Fig. 2 except for the Al composition ratios.

The light-emitting thyristor 12 of the semiconductor device 1200 in Fig. 5 satisfies the aforementioned conditional expressions (1) and (2).

Further, the light-emitting thyristor 12 of the semiconductor device 1200 in Fig. 5 satisfies the following conditional expression (3a):

$$CRacl < CRng = CRpg < CRcll \qquad (3a)$$

Alternatively, the light-emitting thyristor 12 satisfies the following conditional expression (6a) equivalent to the conditional expression (3a):

$$BGacl < BGng = BGpg < BGcll \qquad (6a)$$

However, CRng = CRpg in the expression (3a) does not necessarily have to be satisfied. The light-emitting thyristor 12 may also be formed so as to satisfy the following conditional expressions (4a) and (5a) instead of the conditional expression (3a):

$$CRacl < CRpg < CRcll \qquad (4a)$$

$$CRacl < CRng < CRcll \qquad (5a)$$

Alternatively, the light-emitting thyristor 12 may also be formed so as to satisfy the following conditional expressions (7a) and (8a) equivalent to the conditional expressions (4a) and (5a):

$$BGacl < BGpg < BGcll \qquad (7a)$$

$$BGacl < BGng < BGcll \qquad (8a)$$

Since the semiconductor device 1200 and the light-emitting device chip 120 in Fig. 6 satisfy the conditional expressions (1), (2) and (6a) or the conditional expressions (1), (2), (7a) and (8a), the amount of light emission increases due to the rise in the luminous efficiency similarly to the case of the semiconductor device 1000 and the light-emitting device chip 100 in Fig. 2.

(1-6) Third Modification of First Embodiment

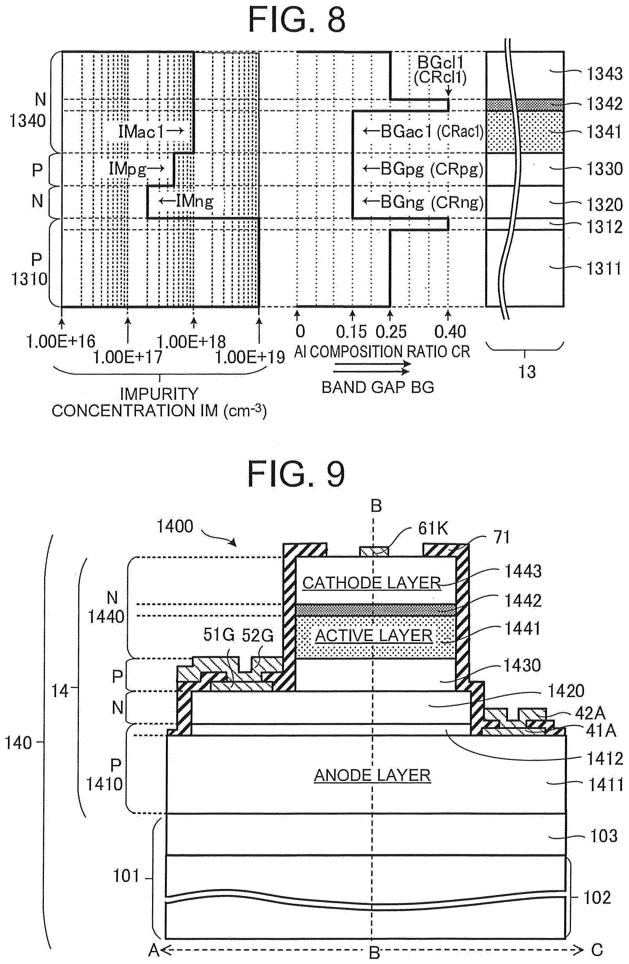

Fig. 7 is a schematic cross-sectional view showing the structure of a semiconductor device 1300 of a third modification of the first embodiment (i.e., cross-sectional structure corresponding to the sections of Fig. 1 along the line A-B-C). Fig. 8 is a diagram showing an example of the impurity concentration and the Al composition ratio of each semiconductor layer in a light-emitting thyristor 13 of the semiconductor device 1300 in Fig. 7. While cases where the first conductivity type is the P type and the second conductivity type is the N type have been described in the examples of Fig. 2 and Fig. 4, a case where the first conductivity type is the N type and the second conductivity type is the P type will be described in the example of Fig. 7. Namely, the example of Fig. 7 is an example obtained by changing the P type and the N type in the example of Fig. 4 respectively to the N type and the P type.

The light-emitting thyristor 13 of the semiconductor device 1300 includes an N-type first semiconductor layer 1340, a P-type second semiconductor layer (P-type gate layer) 1330, an N-type third semiconductor layer (N-type gate layer) 1320, and a P-type fourth semiconductor layer 1310. The semiconductor device 1300 includes a cathode electrode 61K as a first electrode electrically connected with the first semiconductor layer 1340, a gate electrode 51G as a second electrode electrically connected with the second semiconductor layer (P-type gate layer) 1330, and an anode electrode 41A as a third electrode electrically connected with the fourth semiconductor layer 1310. The anode electrode 41A is connected with anode wiring 42A.

As shown in Fig. 7, the N-type first semiconductor layer 1340 includes a cathode layer 1343 as a first layer electrically connected with the cathode electrode 61K, a hole cladding layer (barrier layer) 1342 as a second layer arranged adjacent to the cathode layer 1343, and an active layer 1341 as a third layer arranged adjacent to the hole cladding layer 1342. The P-type fourth semiconductor layer 1310 includes an anode layer 1311 and an electron cladding layer 1312 arranged adjacent to the anode layer 1311.

The light-emitting thyristor 13 of the semiconductor device 1300 in Fig. 7 satisfies the aforementioned conditional expressions (1) and (2).

Further, the light-emitting thyristor 13 satisfies the aforementioned conditional expression (3). Alternatively, the light-emitting thyristor 13 satisfies the conditional expression (6) equivalent to the conditional expression (3).

However, the light-emitting thyristor 13 may also be formed so as to satisfy the aforementioned conditional expressions (4) and (5) instead of the conditional expression (3). Alternatively, the light-emitting thyristor 13 may also be formed so as to satisfy the aforementioned conditional expressions (7) and (8) equivalent to the conditional expressions (4) and (5).

In the semiconductor device 1300, by the hole cladding layer 1342 satisfying the conditional expression BGac1 < BGcl1 as indicated by the aforementioned conditional expression (6) or conditional expressions (7) and (8), the movement of holes in the active layer 1341 towards the cathode layer 1343 is limited and the holes are confined in the active layer 1341. With such a hole confinement effect, the probability of the recombination of an electron heading from the cathode layer 1343 towards the anode layer 1311 with a hole in the active layer 1341 increases and the luminous efficiency rises, and accordingly, the amount of light emission increases.

Further, in the semiconductor device 1300, the impurity concentration IMng of the third semiconductor layer (N-type gate layer) 1320 and the impurity concentration IMpg of the second semiconductor layer (P-type gate layer) 1330 are set low and the impurity concentration IMac1 of the active layer 1341 is set high as indicated by the aforementioned conditional expressions (1) and (2). Thus, the carrier mobility in the third semiconductor layer (N-type gate layer) 1320 and the second semiconductor layer (P-type gate layer) 1330 gets high and the occurrence probability of the recombination in the third semiconductor layer (N-type gate layer) 1320 and the second semiconductor layer (P-type gate layer) 1330 gets low. Meanwhile, the carrier mobility in the active layer 1341 gets low and the occurrence probability of the recombination in the active layer 1341 gets high. Therefore, the occurrence probability of the recombination of an electron and a hole in the active layer 1341 increases and the luminous efficiency rises, and accordingly, the amount of light emission increases.

Furthermore, in the semiconductor device 1300, the active layer 1341 is provided in an upper part (i.e., on a side farther from the substrate part 101) of the light-emitting thyristor 13 as a semiconductor laminated structure and the light generated in the active layer 1341 is extracted in the upward direction in Fig. 7, by which the absorption of the light generated in the active layer 1041 is reduced and the light extraction efficiency is increased.

As described above, according to the semiconductor device 1300 and a light-emitting device chip 130 in this modification, the amount of light emission increases due to the rise in the luminous efficiency in comparison with the conventional gate light emission type light-emitting thyristors.

(1-7) Fourth Modification of First Embodiment

Fig. 9 is a schematic cross-sectional view showing the structure of a semiconductor device 1400 of a fourth modification of the first embodiment (i.e., cross-sectional structure corresponding to the sections of Fig. 1 along the line A-B-C). The semiconductor device 1400 differs from the semiconductor device 1300 shown in Fig. 7 in that a second semiconductor layer (P-type gate layer) 1430 is formed in a region smaller than a third semiconductor layer (N-type gate layer) 1420 and a gate electrode 51G is formed on the third semiconductor layer (N-type gate layer) 1420. Except this feature, the semiconductor device 1400 and a light-emitting device chip 140 in Fig. 9 are the same as the semiconductor device 1300 and the light-emitting device chip 130 in Fig. 7.

A light-emitting thyristor 14 of the semiconductor device 1400 includes an N-type first semiconductor layer 1440, the P-type second semiconductor layer (P-type gate layer) 1430, the N-type third semiconductor layer (N-type gate layer) 1420, and a P-type fourth semiconductor layer 1410. The semiconductor device 1400 includes a cathode electrode 61K electrically connected with the first semiconductor layer 1440, the gate electrode 51G electrically connected with the third semiconductor layer (N-type gate layer) 1420, and an anode electrode 41A electrically connected with the fourth semiconductor layer 1410.

As shown in Fig. 9, the N-type first semiconductor layer 1440 includes a cathode layer 1443 as a first layer electrically connected with the cathode electrode 61K, a hole cladding layer (barrier layer) 1442 as a second layer arranged adjacent to the cathode layer 1443, and an active layer 1441 as a third layer arranged adjacent to the hole cladding layer 1442. The P-type fourth semiconductor layer 1410 includes an anode layer 1411 and an electron cladding layer 1412.

The constituent materials of the light-emitting thyristor 14 of the semiconductor device 1400 in Fig. 9 are the same as those of the aforementioned light-emitting thyristor 13 of the semiconductor device 1300 in Fig. 7. Thus, according to the semiconductor device 1400 and the light-emitting device chip 140 in Fig. 9, the amount of light emission increases due to the rise in the luminous efficiency for the same reason as in the light-emitting thyristor 13 of the semiconductor device 1300 in Fig. 7.

(2) Second Embodiment

(2-1) Configuration

Fig. 10 is a schematic cross-sectional view showing the structure of a semiconductor device 2000 in the second embodiment (i.e., cross-sectional structure corresponding to the sections of Fig. 1 along the line A-B-C). In the first embodiment (Fig. 2), the description was given of an example in which the first semiconductor layer 1040 including the active layer 1041 is arranged on a side farther from the substrate part 101 than the fourth semiconductor layer 1010. In contrast, the description in the second embodiment will be given of an example in which a first semiconductor layer 2010 including an active layer 2013 is arranged on a side closer to the substrate part 101 than a fourth semiconductor layer 2040.

As shown in Fig. 10, a light-emitting thyristor 20 includes the first semiconductor layer 2010 of a first conductivity type, a second semiconductor layer (P-type gate layer) 2020 of a second conductivity type different from the first conductivity type arranged adjacent to the first semiconductor layer 2010, a third semiconductor layer (N-type gate layer) 2030 of the first conductivity type arranged adjacent to the second semiconductor layer 2020, and the fourth semiconductor layer 2040 of the second conductivity type arranged adjacent to the third semiconductor layer 2030.

In the semiconductor device 2000 in Fig. 10, the first semiconductor layer 2010 of the first conductivity type is an N-type semiconductor layer, the second semiconductor layer 2020 of the second conductivity type is a P-type gate layer, the third semiconductor layer 2030 of the first conductivity type is an N-type gate layer, and the fourth semiconductor layer 2040 of the second conductivity type is a P-type semiconductor layer.

Further, the semiconductor device 2000 in Fig. 10 includes a cathode electrode 41K as a first electrode electrically connected with the first semiconductor layer 2010, a gate electrode 51G as a second electrode electrically connected with the second semiconductor layer (P-type gate layer) 2020, and an anode electrode 61A as a third electrode electrically connected with the fourth semiconductor layer 2040.

As shown in Fig. 10, the N-type first semiconductor layer 2010 includes a cathode layer 2011 as a first layer electrically connected with the cathode electrode 41K, a hole cladding layer (barrier layer) 2012 as a second layer arranged adjacent to the cathode layer 2011, and an active layer 2013 as a third layer arranged adjacent to the hole cladding layer 2012.

As shown in Fig. 10, the P-type fourth semiconductor layer 2040 includes an anode layer 2042 electrically connected with the anode electrode 61A and an electron cladding layer 2041 arranged between the anode layer 2042 and the third semiconductor layer 2030.

Fig. 11 is a diagram showing an example of the impurity concentration IM ($cm^{-3}$) and the Al composition ratio CR of each semiconductor layer in the light-emitting thyristor 20 of the semiconductor device 2000.

Let IMng represent the impurity concentration of the third semiconductor layer (N-type gate layer) 2030, IMpg represent the impurity concentration of the second semiconductor layer (P-type gate layer) 2020, and IMac2 represent the impurity concentration of the active layer 2013 as the third layer of the first semiconductor layer 2010, the light-emitting thyristor 20 satisfies the following conditional expressions (9) and (10):

$$IMpg < IMac2 \qquad\qquad (9)$$

$$IMng < IMac2 \qquad\qquad (10)$$

In the example of Fig. 11, the following numerical examples are shown as the impurity concentrations:

$$IMac2 \approx 1 \times 10^{18} \ (cm^{-3})$$

$$IMpg \approx 5 \times 10^{17} \ (cm^{-3})$$

$$IMng \approx 2 \times 10^{17} \ (cm^{-3})$$

However, the impurity concentrations are not limited to the example of Fig. 11.

Further, let CRng represent the Al composition ratio of the third semiconductor layer (N-type gate layer) 2030, CRpg represent the Al composition ratio of the second semiconductor layer (P-type gate layer) 2020, CRac2 represent the Al composition ratio of the active layer 2013, and CRcl2 represent the Al composition ratio of the hole cladding layer 2012, the light-emitting thyristor 20 satisfies the following conditional expression (11):

$$CRac2 = CRng = CRpg < CRcl2 \qquad (11)$$

However, CRac2 = CRng = CRpg in the expression (11) does not necessarily have to be satisfied. The light-emitting thyristor 20 may also be formed so as to satisfy the following conditional expressions (12) and (13) instead of the conditional expression (11):

$$CRac2 \leq CRpg < CRcl2 \qquad (12)$$

$$CRac2 \leq CRng < CRcl2 \qquad (13)$$

The Al composition ratio CR of each semiconductor layer of the light-emitting thyristor 20 corresponds to the band gap BG of each semiconductor layer. Thus, the conditional expressions (11) to (13) are equivalent to the following conditional expressions (14) to (16) using the band gap:

$$BGac2 = BGng = BGpg < BGcl2 \qquad (14)$$

$$BGac2 \leq BGpg < BGcl2 \qquad (15)$$

$$BGac2 \leq BGng < BGcl2 \qquad (16)$$

where BGpg represents the band gap of the second semiconductor layer (P-type gate layer) 2020, BGng represents the band gap of the third semiconductor layer (N-type gate layer) 2030, BGac2 represents the band gap of the active layer 2013, and BGcl2 represents the band gap of the hole cladding layer 2012.
In Fig. 11, the following numerical examples are shown as the Al composition ratios:

$$CRac2 = CRng = CRpg \approx 0.15$$

$$CRcl2 \approx 0.40$$

However, the Al composition ratios are not limited to the example of Fig. 11.
In a case where the light-emitting thyristor 20 is formed with AlGaAs-based semiconductor materials, each semiconductor layer can be configured as below. The anode layer 2042 of the fourth semiconductor layer 2040 is formed with a P-type $Al_{0.25}Ga_{0.75}As$ layer, and the electron cladding layer 2041 of the fourth semiconductor layer 2040 is formed with a P-type $Al_{0.4}Ga_{0.6}As$ layer. The third semiconductor layer (N-type gate layer) 2030 is formed with an N-type $Al_{0.15}Ga_{0.85}As$ layer, and the second semiconductor layer (P-type gate layer) 2020 is formed with a P-type $Al_{0.15}Ga_{0.85}As$ layer. In the first semiconductor layer 2010, the active layer 2013 is formed with an N-type $Al_{0.15}Ga_{0.85}As$ layer, the hole cladding layer 2012 is formed with an N-type $Al_{0.4}Ga_{0.6}As$ layer, and the cathode layer 2011 is formed with an N-type $Al_{0.25}Ga_{0.75}As$ layer.
The Al composition ratio CRcl2 of the hole cladding layer 2012 is desired to be within a range from 0.2 to 1.0.
Further, the Al composition ratio CRac2 of the active layer 2013 is desired to be within a range from 0.14 to 0.18, and the Al composition ratios CRpg and CRng of the second semiconductor layer (P-type gate layer) 2020 and the third semiconductor layer (N-type gate layer) 2030 are desired to be within a range from 0.14 to 0.3.
The reason for setting the band gaps BGpg and BGng at small values, by setting the Al composition ratios CRpg and CRng of the second semiconductor layer (P-type gate layer) 2020 and the third semiconductor layer (N-type gate layer) 2030 at small values, and lowering the impurity concentrations IMpg and IMng is to increase the carrier mobility in the second semiconductor layer (P-type gate layer) 2020 and the third semiconductor layer (N-type gate layer) 2030 and thereby lower the occurrence probability of the recombination of an electron and a hole in the second semiconductor layer (P-type gate layer) 2020 and the third semiconductor layer (N-type gate layer) 2030.

The reason for setting the band gap BGac2 at a small value, by setting the Al composition ratio CRac2 of the active layer 2013 at a small value, and raising the impurity concentration IMac2 is to increase the occurrence probability of the recombination of an electron and a hole in the active layer 2013.

Further, the reason for providing the hole cladding layer 2012 of the high Al composition ratio CRcl2 and the wide band gap BGcl2 between the active layer 2013 and the cathode layer 2011 is to make the hole cladding layer 2012 work as a barrier layer against holes heading from the anode layer 2042 towards the cathode layer 2011 and thereby increase the occurrence probability of the recombination of a hole and an electron in the active layer 2013.

(2-2) Operation

In the semiconductor device 2000, the drive IC part supplies the gate current from the gate electrode 51G to the cathode electrode 41K, and thereby the light-emitting thyristor 20 is brought into the lighted state (light emission state), i.e., the on state. Further, the drive IC part lets current higher than or equal to the holding current flow between the anode electrode 61A and the cathode electrode 41K, and thereby the lighted state is maintained. The light emission from the light-emitting thyristor 20 is mainly caused by the recombination of an electron in the active layer 2013 and a hole moving from the second semiconductor layer (P-type gate layer) 2020 into the active layer 2013. Light generated by the recombination travels upward in Fig. 10 and exits from the top surface of the anode layer 2042 or the like.

When the light-emitting thyristor 20 is in the lighted state, the recombination of a hole and an electron occurs also in the third semiconductor layer (N-type gate layer) 2030 and the second semiconductor layer (P-type gate layer) 2020. However, the carrier mobility in the active layer 2013 is low since the impurity concentration IMac2 of the active layer 2013 is set higher than the impurity concentrations IMng and IMpg of the third semiconductor layer (N-type gate layer) 2030 and the second semiconductor layer (P-type gate layer) 2020 as indicated by the aforementioned conditional expressions (9) and (10). Thus, in the active layer 2013, the recombination occurs at an occurrence probability higher than occurrence probabilities of the recombination in the third semiconductor layer (N-type gate layer) 2030 and the second semiconductor layer (P-type gate layer) 2020. Namely, if the impurity concentration IMac2 of the active layer 2013 is set higher than the impurity concentrations IMpg and IMng of the second semiconductor layer (P-type gate layer) 2020 and the third semiconductor layer (N-type gate layer) 2030, the concentration of carries (electrons) in the active layer 2013 increases, and thus the occurrence probability of the recombination of a hole and an electron increases and the luminous efficiency rises. Accordingly, the amount of light emission increases.

Further, in a case where the band gap BGcl2 of the hole cladding layer 2012 is wider than the band gaps BGpg and BGng of the second semiconductor layer (P-type gate layer) 2020 and the third semiconductor layer (N-type gate layer) 2030 as indicated by the aforementioned conditional expression (14) or conditional expressions (15) and (16), holes that have moved from the second semiconductor layer (P-type gate layer) 2020 to the active layer 2013 are received by the hole cladding layer 2012, by which the amount of holes leaking from the hole cladding layer 2012 to the cathode layer 2011 is reduced. Namely, since the hole cladding layer 2012 satisfying the aforementioned conditional expressions (15) and (16) has the function as a barrier layer limiting the passage of carriers, the leakage of the holes as carries to the cathode layer 2011 that have moved from the second semiconductor layer (P-type gate layer) 2020 to the active layer 2013 is reduced. Accordingly, the amount of carriers in the active layer 2013 hardly decreases and the occurrence probability of the recombination in the active layer 2013 increases, and thus the amount of light emission increases due to the rise in the luminous efficiency.

(2-3) Effect

As described above, in the semiconductor device 2000, the effect of limiting the movement of holes in the active layer 2013 is achieved by the hole cladding layer 2012 satisfying the conditional expression BGac2 < BGcl2 as indicated by the aforementioned conditional expression (14) or conditional expressions (15) and (16). With this effect, the probability of the recombination of an electron heading from the cathode layer 2011 towards the anode layer 2042 with a hole in the active layer 2013 increases and the luminous efficiency rises, and accordingly, the amount of light emission increases.

Further, in the semiconductor device 2000, the impurity concentration IMng of the third semiconductor layer (N-type gate layer) 2030 and the impurity concentration IMpg of the second semiconductor layer (P-type gate layer) 2020 are set low and the impurity concentration IMac2 of the active layer 2013 is set high as indicated by the conditional expressions (9) and (10). Thus, the carrier mobility in the third semiconductor layer (N-type gate layer) 2030 and the second semiconductor layer (P-type gate layer) 2020 gets high and the recombination in the third semiconductor layer (N-type gate layer) 2030 and the second semiconductor layer (P-type gate layer) 2020 is inhibited. Meanwhile, the carrier mobility in the active layer 2013 gets low and the recombination in the active layer 2013 increases. Therefore, the occurrence probability of the recombination of a hole and an electron in the active layer 2013 increases and the luminous efficiency rises, and accordingly, the amount of light emission increases.

Furthermore, in the semiconductor device 2000, the area of the active layer 2013 is larger than the area of the active layer in the first embodiment, and thus the density of electric current flowing into the light-emitting thyristor 20 does not increase excessively. Accordingly, the luminous efficiency of the light-emitting thyristor 20 can be increased and the amount of emitted light increases.

As described above, according to the semiconductor device 2000 and a light-emitting device chip 200 in the second embodiment, the amount of light emission increases due to the rise in the luminous efficiency in comparison with the conventional gate light emission type light-emitting thyristors.

(2-4) First Modification of Second Embodiment

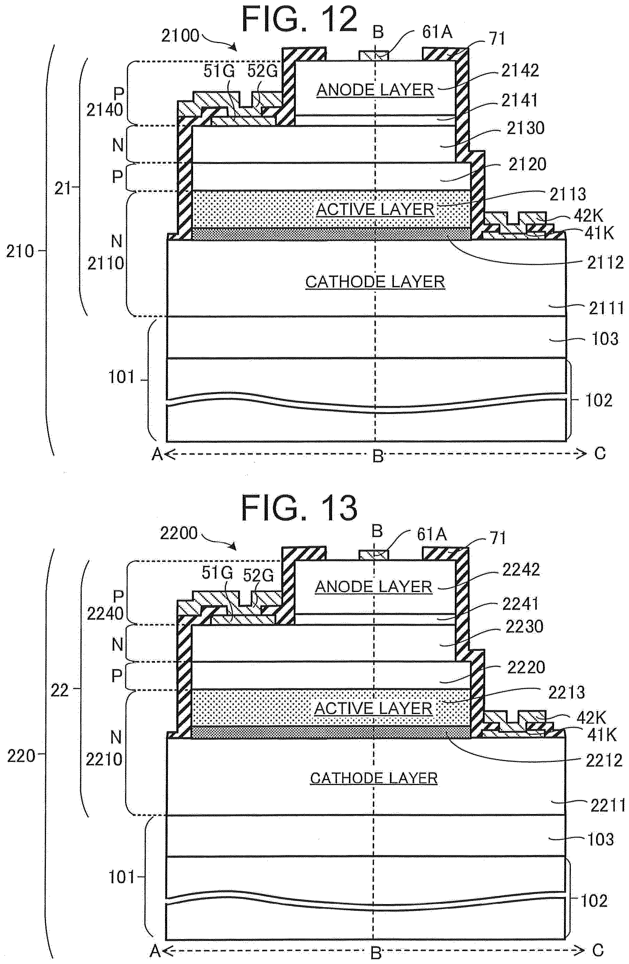

Fig. 12 is a schematic cross-sectional view showing the structure of a semiconductor device 2100 of a first modification of the second embodiment (i.e., cross-sectional structure corresponding to the sections of Fig. 1 along the line A-B-C). The semiconductor device 2100 differs from the semiconductor device 2000 shown in Fig. 10 in that a third semiconductor layer (N-type gate layer) 2130 is formed in a large region similar to a second semiconductor layer (P-type gate layer) 2120 (i.e., a large region including a formation region of a gate electrode 51G) and the gate electrode 51G is formed on the third semiconductor layer (N-type gate layer) 2130. Except this feature, the semiconductor device 2100 and a light-emitting device chip 210 in Fig. 12 are the same as the semiconductor device 2000 and the light-emitting device chip 200 in Fig. 10.

A light-emitting thyristor 21 of the semiconductor device 2100 in Fig. 12 includes an N-type first semiconductor layer 2110, the P-type second semiconductor layer (P-type gate layer) 2120, the N-type third semiconductor layer (N-type gate layer) 2130, and a P-type fourth semiconductor layer 2140. The first semiconductor layer 2110 includes a cathode layer 2111 as a first layer, a hole cladding layer (barrier layer) 2112 as a second layer, and an active layer 2113 as a third layer. The fourth semiconductor layer 2140 includes an anode layer 2142 and a hole cladding layer 2141. The first to fourth semiconductor layers 2110, 2120, 2130 and 2140 of the light-emitting thyristor 21 in Fig. 12 are formed with the same semiconductor materials as the first to fourth semiconductor layers 2010, 2020, 2030 and 2040 of the light-emitting thyristor 20 in Fig. 10. Thus, the light-emitting thyristor 21 in Fig. 12 satisfies the aforementioned conditional expressions (9) to (16). Accordingly, in the semiconductor device 2100 and the light-emitting device chip 210 in Fig. 12, the amount of light emission increases due to the rise in the luminous efficiency for the same reason as in the semiconductor device 2000 and the light-emitting device chip 200 in Fig. 10.

(2-5) Second Modification of Second Embodiment

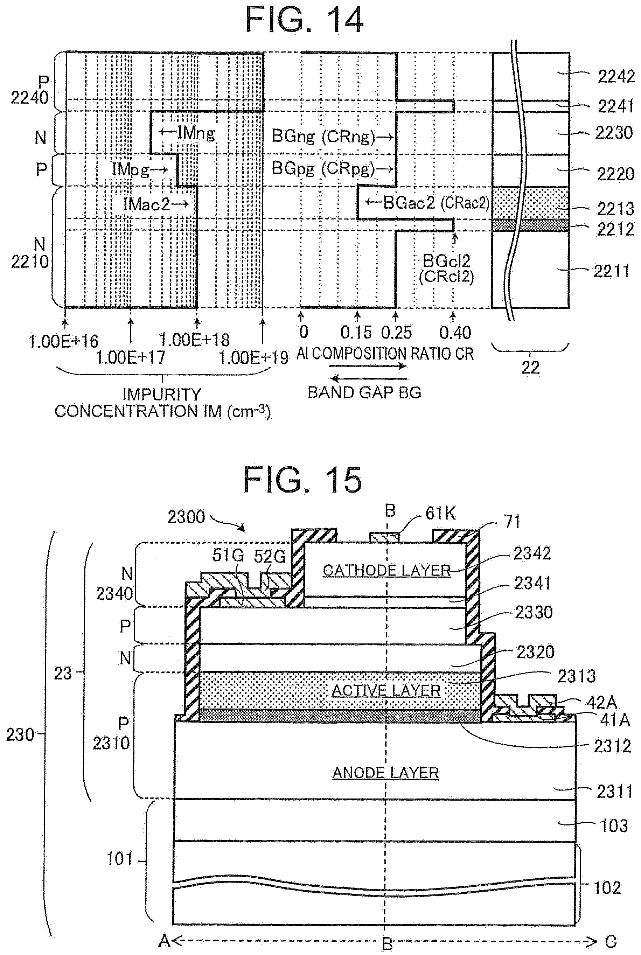

Fig. 13 is a schematic cross-sectional view showing the structure of a semiconductor device 2200 of a second modification of the second embodiment (i.e., cross-sectional structure corresponding to the sections of Fig. 1 along the line A-B-C). Fig. 14 is a diagram showing an example of the impurity concentration and the Al composition ratio of each semiconductor layer in a light-emitting thyristor 22 of the semiconductor device 2200 in Fig. 13. The semiconductor device 2200 differs from the semiconductor device 2100 shown in Fig. 12 in that the Al composition ratio CRng of a third semiconductor layer (N-type gate layer) 2230 and the Al composition ratio CRpg of a second semiconductor layer (P-type gate layer) 2220 are higher than the Al composition ratio CRac2 of an active layer 2213. Except this feature, the semiconductor device 2200 and a light-emitting device chip 220 in Fig. 13 are the same as the semiconductor device 2100 and the light-emitting device chip 210 in Fig. 12.

The light-emitting thyristor 22 of the semiconductor device 2200 in Fig. 13 includes an N-type first semiconductor layer 2210, the P-type second semiconductor layer (P-type gate layer) 2220, the N-type third semiconductor layer (N-type gate layer) 2230, and a P-type fourth semiconductor layer 2240. The first semiconductor layer 2210 includes a cathode layer 2211 as a first layer, a hole cladding layer (barrier layer) 2212 as a second layer, and the active layer 2213 as a third layer. The fourth semiconductor layer 2240 includes an anode layer 2242 and an electron cladding layer 2241. The first and fourth semiconductor layers 2210 and 2240 of the light-emitting thyristor 22 in Fig. 13 are formed with the same semiconductor materials as the first and fourth semiconductor layers 2110 and 2140 of the light-emitting thyristor 21 in Fig. 12. The second and third semiconductor layers 2220 and 2230 in Fig. 13 are the same as the second and third semiconductor layers 2120 and 2130 of the light-emitting thyristor 21 in Fig. 12 except for the Al composition ratios.

Thus, the light-emitting thyristor 22 of the semiconductor device 2200 in Fig. 13 satisfies the aforementioned conditional expressions (9) and (10).

Further, the light-emitting thyristor 22 of the semiconductor device 2200 in Fig. 13 satisfies the following conditional expression (11a):

$$CRac2 < CRng = CRpg < CRcl2 \qquad (11a)$$

Alternatively, the light-emitting thyristor 22 satisfies the following conditional expression (12a) equivalent to the conditional expression (11a):

$$BGac2 < BGng = BGpg < BGcl2 \qquad (12a)$$

However, CRng = CRpg in the expression (11a) does not necessarily have to be satisfied. The light-emitting thyristor 22 may also be formed so as to satisfy the following conditional expressions (13a) and (14a) instead of the conditional expression (11a):

$$CRac2 < CRpg < CRcl2 \qquad (13a)$$

$$CRac2 < CRng < CRcl2 \qquad (14a)$$

Alternatively, the light-emitting thyristor 22 may also be formed so as to satisfy the following conditional expressions (15a) and (16a) equivalent to the conditional expressions (13a) and (14a):

$$BGac2 < BGpg < BGcl2 \qquad (15a)$$

$$BGac2 < BGng < BGcl2 \qquad (16a)$$

Since the semiconductor device 2200 and the light-emitting device chip 220 in Fig. 13 satisfy the conditional expressions (9), (10) and (12a) or the conditional expressions (9), (10), (15a) and (16a), the amount of light emission increases due to the rise in the luminous efficiency for the same reason as in the semiconductor device 2000 and the light-emitting device chip 200 in Fig. 10.

(2-6) Third Modification of Second Embodiment

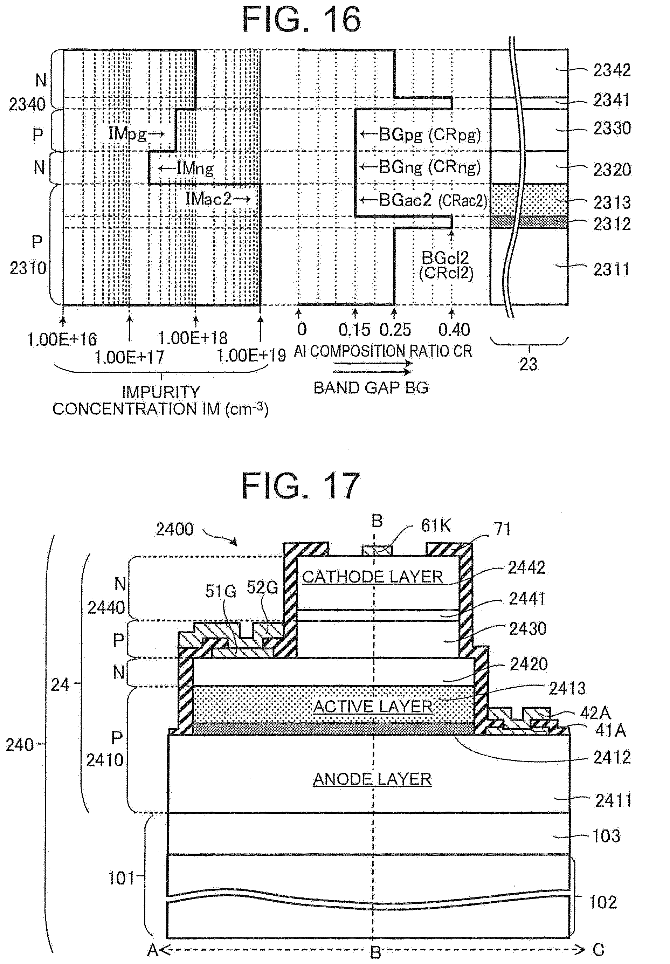

Fig. 15 is a schematic cross-sectional view showing the structure of a semiconductor device 2300 of a third modification of the second embodiment (i.e., cross-sectional structure corresponding to the sections of Fig. 1 along the line A-B-C). Fig. 16 is a diagram showing an example of the impurity concentration and the Al composition ratio of each semiconductor layer in a light-emitting thyristor 23 of the semiconductor device 2300 in Fig. 15. While cases where the first conductivity type is the N type and the second conductivity type is the P type have been described in the examples of Fig. 10 and Fig. 12, a case where the first conductivity type is the P type and the second conductivity type is the N type will be described in the example of Fig. 15. Namely, the example of Fig. 15 is an example obtained by changing the N type and the P type in the example of Fig. 12 respectively to the P type and the N type.

The light-emitting thyristor 23 of the semiconductor device 2300 includes a P-type first semiconductor layer 2310, an N-type second semiconductor layer (N-type gate layer) 2320, a P-type third semiconductor layer (P-type gate layer) 2330, and an N-type fourth semiconductor layer 2340. The semiconductor device 2300 includes a cathode electrode 61K as a first electrode electrically connected with the fourth semiconductor layer 2340, a gate electrode 51G as a second electrode electrically connected with the third semiconductor layer (P-type gate layer) 2330, and an anode electrode 41A as a third electrode electrically connected with the first semiconductor layer 2310.

As shown in Fig. 15, the P-type first semiconductor layer 2310 includes an anode layer 2311 as a first layer electrically connected with the anode electrode 41A, an electron cladding layer (barrier layer) 2312 as a second layer arranged adjacent to the anode layer 2311, and an active layer 2313 as a third layer arranged adjacent to the electron cladding layer 2312. The N-type fourth semiconductor layer 2340 includes a cathode layer 2342 and a hole cladding layer 2341 arranged adjacent to the cathode layer 2342.

The light-emitting thyristor 23 of the semiconductor device 2300 in Fig. 15 satisfies the conditional expressions (9) and (10).

Further, the light-emitting thyristor 23 satisfies the aforementioned conditional expression (11). Alternatively, the light-emitting thyristor 23 satisfies the conditional expression (14) equivalent to the conditional expression (11).

However, CRng = CRpg in the conditional expression (11) does not necessarily have to be satisfied. The light-emitting thyristor 23 may also be formed so as to satisfy the conditional expressions (12) and (13) instead of the conditional expression (11). Alternatively, the light-emitting thyristor 23 may also be formed so as to satisfy the conditional expressions (15) and (16) equivalent to the conditional expressions (12) and (13).

In the semiconductor device 2300, by the electron cladding layer 2312 satisfying the conditional expression BGac2 < BGcl2 as indicated by the aforementioned conditional expression (14) or conditional expressions (15) and (16), the movement of electrons in the active layer 2313 towards the anode layer 2311 is limited and the electrons are confined in the active layer 2313. With this electron confinement, the probability of the recombination of an electron heading from the cathode layer 2342 towards the anode layer 2311 with a hole in the active layer 2313 increases and the luminous efficiency rises, and accordingly, the amount of light emission increases.

Further, in the semiconductor device 2300, the impurity concentration IMpg of the third semiconductor layer (P-type gate layer) 2330 and the impurity concentration IMng of the second semiconductor layer (N-type gate layer) 2320 are set low and the impurity concentration IMac2 of the active layer 2313 is set high as indicated by the conditional expressions (9) and (10). Thus, the carrier mobility in the third semiconductor layer (P-type gate layer) 2330 and the second semiconductor layer (N-type gate layer) 2320 gets high and the recombination in the third semiconductor layer (P-type gate layer) 2330 and the second semiconductor layer (N-type gate layer) 2320 is inhibited. Meanwhile, the carrier mobility in the active layer 2313 gets low and the recombination in the active layer 2313 increases. Therefore, the occurrence probability of the recombination of an electron and a hole in the active layer 2313 increases and the luminous efficiency rises, and accordingly, the amount of light emission increases.

As described above, according to the semiconductor device 2300 and a light-emitting device chip 230 in this modification, the amount of light emission increases due to the rise in the luminous efficiency in comparison with the conventional gate light emission type light-emitting thyristors.

(2-7) Fourth Modification of Second Embodiment

Fig. 17 is a schematic cross-sectional view showing the structure of a semiconductor device 2400 of a fourth modification of the second embodiment (i.e., cross-sectional structure corresponding to the sections of Fig. 1 along the line A-B-C). The semiconductor device 2400 differs from the semiconductor device 2300 shown in Fig. 15 in that a third semiconductor layer (P-type gate layer) 2430 is formed in a region smaller than a second semiconductor layer (N-type gate layer) 2420 and the gate electrode 51G is formed on the second semiconductor layer (N-type gate layer) 2420. Except this feature, the semiconductor device 2400 and a light-emitting device chip 240 in Fig. 17 are the same as the semiconductor device 2300 and the light-emitting device chip 230 in Fig. 15.

A light-emitting thyristor 24 of the semiconductor device 2400 includes a P-type first semiconductor layer 2410, the N-type second semiconductor layer (N-type gate layer) 2420, the P-type third semiconductor layer (P-type gate layer) 2430, and an N-type fourth semiconductor layer 2440. The semiconductor device 2400 includes an anode electrode 41A electrically connected with the first semiconductor layer 2410, a gate electrode 51G electrically connected with the second semiconductor layer (N-type gate layer) 2420, and a cathode electrode 61K electrically connected with the fourth semiconductor layer 2440.

As shown in Fig. 17, the P-type first semiconductor layer 2410 includes an anode layer 2411 as a first layer electrically connected with the anode electrode 41A, an electron cladding layer (barrier layer) 2412 as a second layer, and an active layer 2413 as a third layer. The N-type fourth semiconductor layer 2440 includes a cathode layer 2442 and a hole cladding layer 2441.

The constituent materials of the light-emitting thyristor 24 of the semiconductor device 2400 in Fig. 17 are the same as those of the aforementioned light-emitting thyristor 23 of the semiconductor device 2300 in Fig. 15. Thus, according to the semiconductor device 2400 and the light-emitting device chip 240 in Fig. 17, the amount of light emission increases due to the rise in the luminous efficiency for the same reason as in the light-emitting thyristor 23 of the semiconductor device 2300 in Fig. 15.

(3) Third Embodiment

(3-1) Configuration

Fig. 18 is a schematic cross-sectional view showing the structure of a semiconductor device 3000 in the third embodiment (i.e., cross-sectional structure corresponding to the sections of Fig. 1 along the line A-B-C). In the third embodiment, a description will be given of a semiconductor device and a light-emitting device chip having a structure in which the active layer and the electron cladding layer (or the hole cladding layer) in the first embodiment are combined with the active layer and the hole cladding layer (or the electron cladding layer) in the second embodiment.

As shown in Fig. 18, a light-emitting thyristor 30 of the semiconductor device 3000 includes a first semiconductor layer 3040 of a first conductivity type, a second semiconductor layer 3030 of a second conductivity type arranged adjacent to the first semiconductor layer 3040, a third semiconductor layer 3020 of the first conductivity type arranged adjacent to the second semiconductor layer 3030, and a fourth semiconductor layer 3010 of the second conductivity type arranged adjacent to the third semiconductor layer 3020.

In the semiconductor device 3000 in Fig. 18, the first semiconductor layer 3040 of the first conductivity type is a P-type semiconductor layer, the second semiconductor layer 3030 of the second conductivity type is an N-type gate layer, the third semiconductor layer 3020 of the first conductivity type is a P-type gate layer, and the fourth semiconductor layer 3010 of the second conductivity type is an N-type semiconductor layer.

Further, the semiconductor device 3000 in Fig. 18 includes an anode electrode 61A electrically connected with the first semiconductor layer 3040, a gate electrode 51G electrically connected with the third semiconductor layer (P-type gate layer) 3020, and a cathode electrode 41K electrically connected with the fourth semiconductor layer 3010.

As shown in Fig. 18, the P-type first semiconductor layer 3040 includes an anode layer 3043 as a first layer electrically connected with the anode electrode 61A, an electron cladding layer (barrier layer) 3042 as a second layer arranged adjacent to the anode layer 3043, and an active layer 3041 as a third layer arranged adjacent to the electron cladding layer 3042. Namely, the first to third semiconductor layers 3040, 3030 and 3020 of the light-emitting thyristor 30 have a structure similar to that of the first to third semiconductor layers 1040, 1030 and 1020 of the light-emitting thyristor 10 of the semiconductor device 1000 described with reference to Fig. 2 and Fig. 3.

As shown in Fig. 18, the N-type fourth semiconductor layer 3010 includes a cathode layer 3011 as a fourth layer electrically connected with the cathode electrode 41K, a hole cladding layer (barrier layer) 3012 as a fifth layer arranged adjacent to the cathode layer 3011, and an active layer 3013 as a sixth layer arranged adjacent to the hole cladding layer 3012. Namely, the second to fourth semiconductor layers 3030, 3020 and 3010 of the light-emitting thyristor 30 have a structure similar to that of the third to first semiconductor layers 2030, 2020 and 2010 of the light-emitting thyristor 20 of the semiconductor device 2000 described with reference to Fig. 10 and Fig. 11.

The third embodiment has a combined structure as a combination of the first embodiment and the second embodiment, in which a P-type active layer is introduced into a P-type emitter of a conventional gate light emission type light-emitting thyristor and an N-type active layer is introduced into an N-type emitter of a conventional gate light emission type light-emitting thyristor. The active layer 3013 is an N-type $Al_{0.15}Ga_{0.85}As$ layer, for example, and the active layer 3041 is a P-type $Al_{0.15}Ga_{0.85}As$ layer, for example.

Fig. 19 is a diagram showing an example of the impurity concentration IM ($cm^{-3}$) and the Al composition ratio CR of each semiconductor layer in the light-emitting thyristor 30 of the semiconductor device 3000.

As is understandable from comparison between Fig. 19 and Fig. 3 (the first embodiment), the first to third semiconductor layers 3040, 3030 and 3020 of the light-emitting thyristor 30 satisfy the conditional expressions (1) to (8) explained with reference to Fig. 2 and Fig. 3 (the first embodiment).

Further, as is understandable from comparison between Fig. 19 and Fig. 11 (the second embodiment), the second to fourth semiconductor layers 3030, 3020 and 3010 of the light-emitting thyristor 30 satisfy the conditional expressions (9) to (16) explained with reference to Fig. 10 and Fig. 11 (the second embodiment).

(3-2) Operation

In the third embodiment, the first to third semiconductor layers 3040, 3030 and 3020 of the light-emitting thyristor 30 operate similarly to the first to third semiconductor layers 1040, 1030 and 1020 of the light-emitting thyristor 10 of the semiconductor device 1000 described with reference to Fig. 2 and Fig. 3 (the first embodiment).

Further, the second to fourth semiconductor layers 3030, 3020 and 3010 of the light-emitting thyristor 30 operate similarly to the third to first semiconductor layers 2030, 2020 and 2010 of the light-emitting thyristor 20 of the semiconductor device 2000 described with reference to Fig. 10 and Fig. 11 (the second embodiment).

(3-3) Effect

According to the third embodiment, the amount of light emission increases due to the rise in the luminous efficiency for the reasons described in the first and second embodiment.

Further, the amount of light emission increases further since light as a combination of light generated in the active layer 3041 and light generated in the active layer 3013 exits as outgoing light from a large region including the top surface of the anode layer 3043.

(3-4) First Modification of Third Embodiment

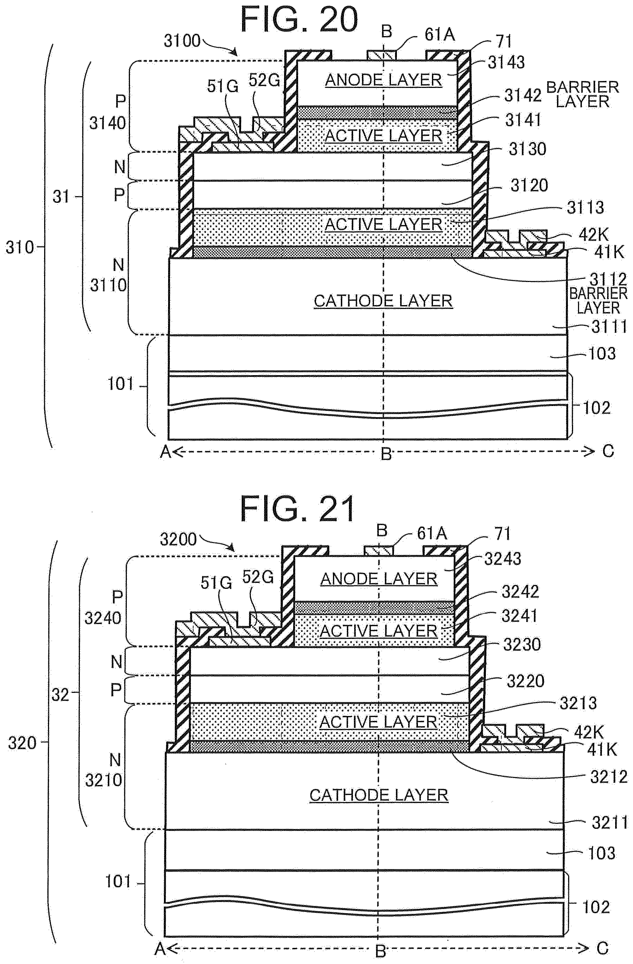

Fig. 20 is a schematic cross-sectional view showing the structure of a semiconductor device 3100 of a first modification of the third embodiment (i.e., cross-sectional structure corresponding to the sections of Fig. 1 along the line A-B-C). The semiconductor device 3100 differs from the semiconductor device 3000 shown in Fig. 18 in that a second semiconductor layer (N-type gate layer) 3130 is formed in a large region similar to a third semiconductor layer (P-type gate layer) 3120 (i.e., a large region including a formation region of a gate electrode 51G) and the gate electrode 51G is formed on the second semiconductor layer (N-type gate layer) 3130. Except this feature, the semiconductor device 3100 and a light-emitting device chip 310 in Fig. 20 are the same as the semiconductor device 3000 and the light-emitting device chip 300 in Fig. 18.

A light-emitting thyristor 31 of the semiconductor device 3100 in Fig. 20 includes a P-type first semiconductor layer 3140, the N-type second semiconductor layer (N-type gate layer) 3130, the P-type third semiconductor layer (P-type gate layer) 3120, and an N-type fourth semiconductor layer 3110. The first semiconductor layer 3140 includes an anode layer 3143 as a first layer, an electron cladding layer (barrier layer) 3142 as a second layer, and an active layer 3141 as a third layer. The fourth semiconductor layer 3110 includes a cathode layer 3111 as a fourth layer, a hole cladding layer (barrier layer) 3112 as a fifth layer, and an active layer 3113 as a sixth layer.

The first to third semiconductor layers 3140, 3130 and 3120 of the light-emitting thyristor 31 have a structure similar to that of the first to third semiconductor layers 1140, 1130 and 1120 of the light-emitting thyristor 11 of the semiconductor device 1100 described with reference to Fig. 4 (the first modification of the first embodiment) and operate similarly to the first to third semiconductor layers 1140, 1130 and 1120 of the light-emitting thyristor 11 of the semiconductor device 1100 described with reference to Fig. 4.

The second to fourth semiconductor layers 3130, 3120 and 3110 of the light-emitting thyristor 31 have a structure similar to that of the third to first semiconductor layers 2130, 2120 and 2110 of the light-emitting thyristor 21 of the semiconductor device 2100 described with reference to Fig. 12 (the first modification of the second embodiment) and operate similarly to the third to first semiconductor layers 2130, 2120 and 2110 of the light-emitting thyristor 21 of the semiconductor device 2100 described with reference to.Fig. 12.

Thus, according to the semiconductor device 3100 and the light-emitting device chip 310 in Fig. 20, the amount of light emission increases due to the rise in the luminous efficiency for the reasons described in the first modification of the first embodiment and the first modification of the second embodiment.

Further, the amount of light emission increases further since light as a combination of light generated in the active layer 3141 and light generated in the active layer 3113 exits as outgoing light from a large region including the top surface of the anode layer 3143.

(3-5) Second Modification of Third Embodiment

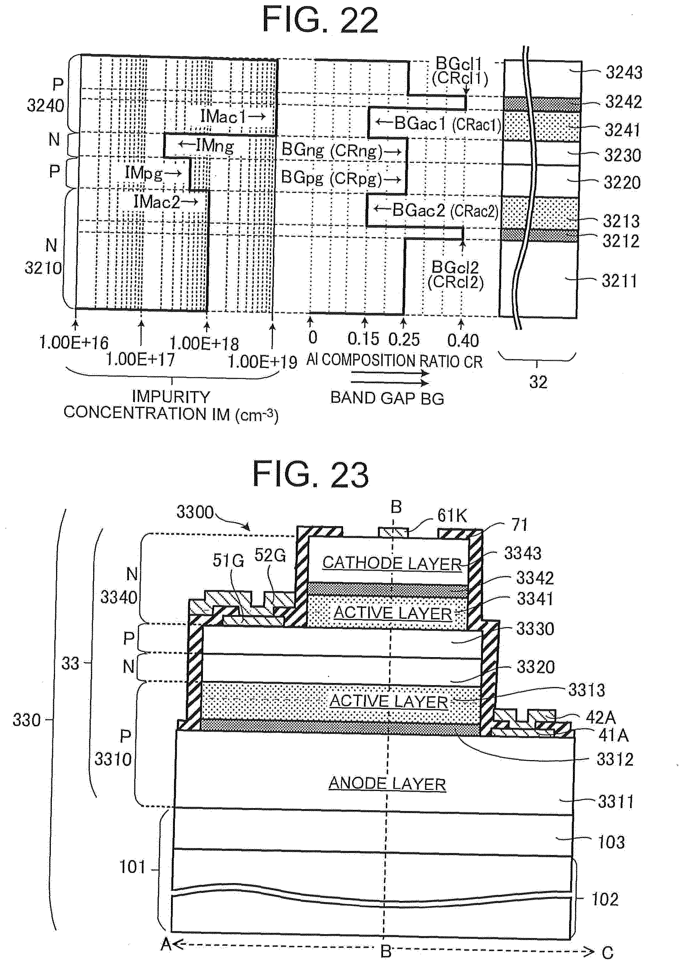

Fig. 21 is a schematic cross-sectional view showing the structure of a semiconductor device 3200 of a second modification of the third embodiment (i.e., cross-sectional structure corresponding to the sections of Fig. 1 along the line A-B-C). Fig. 22 is a diagram showing an example of the impurity concentration and the Al composition ratio of each semiconductor layer in a light-emitting thyristor 32 of the semiconductor device 3200 in Fig. 21. The semiconductor device 3200 differs from the semiconductor device 3100 shown in Fig. 20 in that the Al composition ratio CRng of a second semiconductor layer (N-type gate layer) 3230 and the Al composition ratio CRpg of a third semiconductor layer (P-type gate layer) 3220 are higher than the Al composition ratio CRac1 of an active layer (third layer) 3241 and the Al composition ratio CRac2 of an active layer (sixth layer) 3213. Except this feature, the semiconductor device 3200 in Fig. 21 is the same as the semiconductor device 3100 in Fig. 20.

The light-emitting thyristor 32 of the semiconductor device 3200 in Fig. 21 includes a P-type first semiconductor layer 3240, the N-type second semiconductor layer (N-type gate layer) 3230, the P-type third semiconductor layer (P-type gate layer) 3220, and an N-type fourth semiconductor layer 3210. The first semiconductor layer 3240 includes an anode layer 3243 as a first layer, an electron cladding layer (barrier layer) 3242 as a second layer, and the active layer 3241 as a third layer. The fourth semiconductor layer 3210 includes a cathode layer 3211 as a fourth layer, a hole cladding layer (barrier layer) 3212 as a fifth layer, and the active layer 3213 as a sixth layer.

The first to third semiconductor layers 3240, 3230 and 3220 of the light-emitting thyristor 32 have a structure similar to that of the first to third semiconductor layers 1240, 1230 and 1220 of the light-emitting thyristor 12 of the semiconductor device 1200 described with reference to Fig. 5 (the second modification of the first embodiment) and operate similarly to the first to third semiconductor layers 1240, 1230 and 1220 of the light-emitting thyristor 12 of the semiconductor device 1200 described with reference to Fig. 5.

The second to fourth semiconductor layers 3230, 3220 and 3210 of the light-emitting thyristor 32 have a structure similar to that of the third to first semiconductor layers 2230, 2220 and 2210 of the light-emitting thyristor 22 of the semiconductor device 2200 described with reference to Fig. 13 (the second modification of the second embodiment) and operate similarly to the third to first semiconductor layers 2230, 2220 and 2210 of the light-emitting thyristor 22 of the semiconductor device 2200 described with reference to Fig. 13.

Thus, according to the semiconductor device 3200 and a light-emitting device chip 320 in Fig. 21, the amount of light emission increases due to the rise in the luminous efficiency for the reasons described in the first and second embodiments.

Further, the amount of light emission increases further since light as a combination of light generated in the active layer 3241 and light generated in the active layer 3213 exits as outgoing light from a large region including the top surface of the anode layer 3243.

(3-6) Third Modification of Third Embodiment

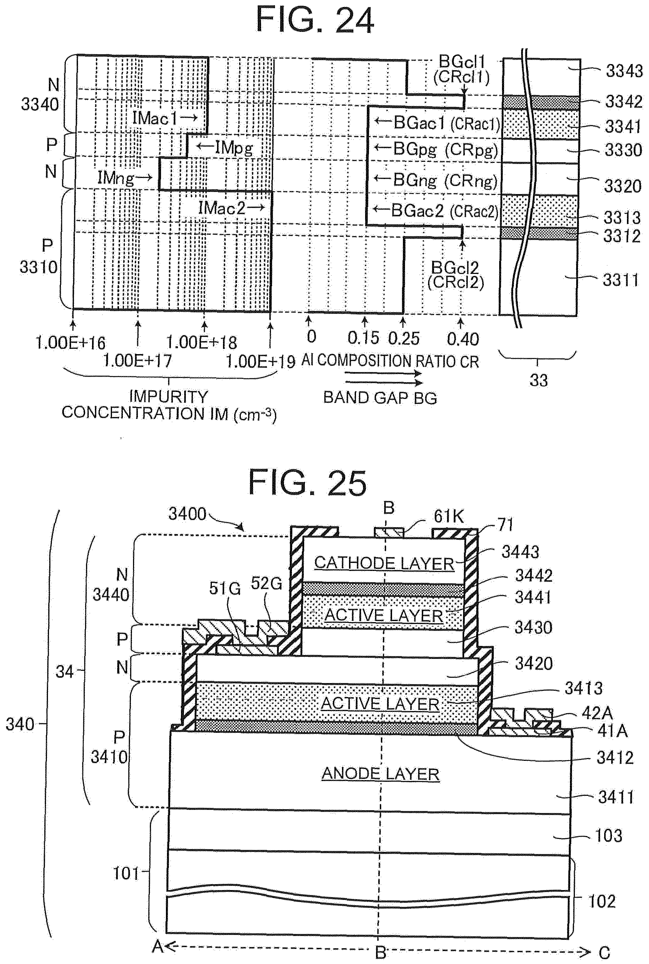

Fig. 23 is a schematic cross-sectional view showing the structure of a semiconductor device 3300 of a third modification of the third embodiment (i.e., cross-sectional structure corresponding to the sections of Fig. 1 along the line A-B-C). Fig. 24 is a diagram showing an example of the impurity concentration and the Al composition ratio of each semiconductor layer in a light-emitting thyristor 33 of the semiconductor device 3300 in Fig. 23. While cases where the first conductivity type is the P type and the second conductivity type is the N type have been described in the examples of Fig. 18 and Fig. 20, a case where the first conductivity type is the N type and the second conductivity type is the P type will be described in the example of Fig. 23 and Fig. 24. Namely, the example of Fig. 23 and Fig. 24 is an example obtained by changing the P type and the N type in the example of Fig. 20 respectively to the N type and the P type.

The light-emitting thyristor 33 of the semiconductor device 3300 in Fig. 23 includes an N-type first semiconductor layer 3340, a P-type second semiconductor layer (P-type gate layer) 3330, an N-type third semiconductor layer (N-type gate layer) 3320, and a P-type fourth semiconductor layer 3310. The semiconductor device 3300 in Fig. 23 includes a cathode electrode 61K electrically connected with the first semiconductor layer 3340, a gate electrode 51G electrically connected with the second semiconductor layer (P-type gate layer) 3330, and an anode electrode 41A electrically connected with the fourth semiconductor layer 3310.

As shown in Fig. 23, the N-type first semiconductor layer 3340 includes a cathode layer 3343 as a first layer electrically connected with the cathode electrode 61K, a hole cladding layer (barrier layer) 3342 as a second layer arranged adjacent to the cathode layer 3343, and an active layer 3341 as a third layer arranged adjacent to the hole cladding layer 3342. Namely, the first to third semiconductor layers 3340, 3330 and 3320 of the light-emitting thyristor 33 have a structure similar to that of the first to third semiconductor layers 1340, 1330 and 1320 of the light-emitting thyristor 13 of the semiconductor device 1300 described with reference to Fig. 7 and Fig. 8 (the third modification of the first embodiment) and operate similarly to the first to third semiconductor layers 1340, 1330 and 1320 of the light-emitting thyristor 13 of the semiconductor device 1300 described with reference to Fig. 7 and Fig. 8.

The P-type fourth semiconductor layer 3310 includes an anode layer 3311 as a fourth layer electrically connected with the anode electrode 41A, an electron cladding layer (barrier layer) 3312 as a fifth layer arranged adjacent to the anode layer 3311, and an active layer 3313 as a sixth layer arranged adjacent to the electron cladding layer 3312. Namely, the second to fourth semiconductor layers 3330, 3320 and 3310 of the light-emitting thyristor 33 have a structure similar to that of the third to first semiconductor layers 2330, 2320 and 2310 of the light-emitting thyristor 23 of the semiconductor device 2300 described with reference to Fig. 15 and Fig. 16 (the third modification of the second embodiment) and operate similarly to the third to first semiconductor layers 2330, 2320 and 2310 of the light-emitting thyristor 23 of the semiconductor device 2300 described with reference to Fig. 15 and Fig. 16.

Thus, according to the semiconductor device 3300 and a light-emitting device chip 330 in Fig. 23, the amount of light emission increases due to the rise in the luminous efficiency for the reasons described in the first and second embodiments.

Further, the amount of light emission increases further since light as a combination of light generated in the active layer 3341 and light generated in the active layer 3313 exits as outgoing light from a large region including the top surface of the cathode layer 3343.

(3-7) Fourth Modification of Third Embodiment

Fig. 25 is a schematic cross-sectional view showing the structure of a semiconductor device 3400 of a fourth modification of the third embodiment (i.e., cross-sectional structure corresponding to the sections of Fig. 1 along the line A-B-C). The semiconductor device 3400 differs from the semiconductor device 3300 shown in Fig. 23 in that a second semiconductor layer (P-type gate layer) 3430 is formed in a region smaller than a third semiconductor layer (N-type gate layer) 3420 and a gate electrode 51G is formed on the third semiconductor layer (N-type gate layer) 3420. Except this feature, the semiconductor device 3400 and a light-emitting device chip 340 in Fig. 25 are the same as the semiconductor device 3300 and the light-emitting device chip 330 in Fig. 23.

A light-emitting thyristor 34 of the semiconductor device 3400 includes an N-type first semiconductor layer 3440, the P-type second semiconductor layer (P-type gate layer) 3430, the N-type third semiconductor layer (N-type gate layer) 3420, and a P-type fourth semiconductor layer 3410. The semiconductor device 3400 includes a cathode electrode 61K electrically connected with the first semiconductor layer 3440, the gate electrode 51G electrically connected with the third semiconductor layer (N-type gate layer) 3420, and an anode electrode 41A electrically connected with the fourth semiconductor layer 3410.

As shown in Fig. 25, the N-type first semiconductor layer 3440 includes a cathode layer 3443 as a first layer electrically connected with the cathode electrode 61K, a hole cladding layer (barrier layer) 3442 as a second layer arranged adjacent to the cathode layer 3443, and an active layer 3441 as a third layer arranged adjacent to the hole cladding layer 3442. The P-type fourth semiconductor layer 3410 includes an anode layer 3411 as a fourth layer electrically connected with the anode electrode 41A, an electron cladding layer (barrier layer) 3412 as a fifth layer arranged adjacent to the anode layer 3411, and an active layer 3413 as a sixth layer arranged adjacent to the electron cladding layer 3412.

Namely, the first to third semiconductor layers 3440, 3430 and 3420 of the light-emitting thyristor 34 have a structure similar to that of the first to third semiconductor layers 1440, 1430 and 1420 of the light-emitting thyristor 14 of the semiconductor device 1400 described with reference to Fig. 9 (the fourth modification of the first embodiment) and operate similarly to the first to third semiconductor layers 1440, 1430 and 1420 of the light-emitting thyristor 14 of the semiconductor device 1400 described with reference to Fig. 9.

Further, the second to fourth semiconductor layers 3430, 3420 and 3410 of the light-emitting thyristor 34 have a structure similar to that of the third to first semiconductor layers 2430, 2420 and 2410 of the light-emitting thyristor 24 of the semiconductor device 2400 described with reference to Fig. 17 (the fourth modification of the second embodiment) and operate similarly to the third to first semiconductor layers 2430, 2420 and 2410 of the light-emitting thyristor 24 of the semiconductor device 2400 described with reference to Fig. 17.

Thus, according to the semiconductor device 3400 and the light-emitting device chip 340 in Fig. 25, the amount of light emission increases due to the rise in the luminous efficiency for the reasons described in the first and second embodiments.

Further, the amount of light emission increases further since light as a combination of light generated in the active layer 3441 and light generated in the active layer 3413 exits as outgoing light from a large region including the top surface of the cathode layer 3443.

(4) Fourth Embodiment

Fig. 26 is a schematic perspective view showing the structure of a substrate unit 400 as a principal part of an optical print head in the fourth embodiment. As shown in Fig. 26, the substrate unit 400 includes a printed wiring board 401 and a plurality of light-emitting device chips 404 arranged like an array. The plurality of light-emitting device chips 404 are fixed on the printed wiring board 401 by using a thermosetting resin or the like. The light-emitting device chip 404 is the light-emitting device chip described in one of the first to third embodiments and their modifications (e.g., the light-emitting device chip 100 shown in Fig. 1 and Fig. 2). The external connection pad 104 of each light-emitting device chip 404 and a connection pad 402 of the printed wiring board 401 are electrically connected to each other by a bonding wire 403. The printed wiring board 401 may be equipped with various types of wiring patterns, electronic components, connectors and so on. The shape of the light-emitting device chip 404 is not limited to that shown in Fig. 26.

Fig. 27 is a schematic cross-sectional view showing the structure of the optical print head 500 in the fourth embodiment. The optical print head 500 is an exposure device of an electrophotographic printer as an image forming device. As shown in Fig. 27, the optical print head 500 includes a base member 501, the substrate unit 400 including the printed wiring board 401 used as a mounting substrate as a COB (Chip On Board) substrate, a lens array 504 including a plurality of upright equal-magnification imaging lenses, a lens holder 505, and clampers 506 as spring members. The base member 501 is a member for fixing the printed wiring board 401, and side faces of the base member 501 are provided with opening parts 503 to be used for fixing the printed wiring board 401 and the lens holder 505 to the base member 501 by use of the clampers 506. The lens holder 505 is formed by injection molding of organic polymeric material or the like, for example. The lens array 504 is a set of optical lenses imaging light emitted from the light-emitting device chips 404 of the substrate unit 400 on a photosensitive drum as an image bearing body. The lens holder 505 holds the lens array 504 at a prescribed position with respect to the base member 501. The clampers 506 clamp and hold components via the opening parts 503 of the base member 501 and opening parts of the lens holder 505.

In the optical print head 500, some of the light-emitting thyristors of the light-emitting device chips 404 (e.g., the light-emitting thyristors 10 in Fig. 1) emit light according to print data, and the light is imaged on the uniformly charged photosensitive drum by the lens array 504. By this process, an electrostatic latent image is formed on the photosensitive drum, and thereafter, an image made of a developing agent is formed (printed) on a print medium (sheet) by a development process, a transfer process and a fixation process.

As described above, the optical print head 500 in the fourth embodiment includes the light-emitting device chips 404 according to one of the first to third embodiments and their modifications, and thus the amount (intensity) of the light applied to the photosensitive drum can be increased. Consequently, adjustment of the amount (intensity) of the light applied to the photosensitive drum is facilitated and improvement of print quality (e.g., printing with high-quality gradation expression) becomes possible.

(5) Fifth Embodiment

(5-1) Configuration

Fig. 28 is a schematic cross-sectional view showing the structure of an image forming device 600 in the fifth embodiment of the present invention. The image forming device 600 is an electrophotographic color printer, for example. The image forming device 600 includes optical print heads 611Y, 611M, 611C and 611K as exposure devices, each of which is the optical print head 500 described in the fourth embodiment.

As shown in Fig. 28, the image forming device 600 includes, as principal components, image formation sections 610Y, 610M, 610C and 610K for forming developing agent images (toner images) on a print medium 626 such as a sheet of paper by an electrophotographic method, a medium supply section 620 for supplying the print medium 626 to the image formation sections 610Y, 610M, 610C and 610K, a conveyance section 630 for conveying the print medium 626, transfer rollers 640 as transfer sections arranged respectively corresponding to the image formation sections 610Y, 610M, 610C and 610K, a fixation device 650 for fixing the toner image transferred onto the print medium 626, and an ejection roller pair 625 as a medium ejection section for ejecting the print medium 626 after passing through the fixation device 650 to the outside. Incidentally, the number of image formation sections of the image forming device 600 may also be three or less or five or more. Further, the image forming device 600 can also be a monochrome printer, in which the number of image formation sections is one, as long as the image forming device 600 is a device forming an image on a print medium 626 by means of the electrophotographic process.

As shown in Fig. 28, the medium supply section 620 includes a sheet cassette 621, a hopping roller 622 for drawing out the print media 626 loaded in the sheet cassette 621 sheet by sheet, a registration roller 623 for conveying the print medium 626 drawn out of the sheet cassette 621, and a roller pair 624 for conveying the print medium 626.

The image formation sections 610Y, 610M, 610C and 610K respectively form a yellow (Y) toner image, a magenta (M) toner image, a cyan (C) toner image and a black (K) toner image on the print medium 626. The image formation sections 610Y, 610M, 610C and 610K are arranged side by side along a medium conveyance path from an upstream side to a downstream side (i.e., from right to left) in a medium conveyance direction (horizontal direction in Fig. 28). The image formation sections 610Y, 610M, 610C and 610K respectively include image formation units 612Y, 612M, 612C and 612K for their colors formed so as to be detachable. The image formation units 612Y, 612M, 612C and 612K arranged in series are provided respectively corresponding to the colors of the image formation sections 610Y, 610M, 610C and 610K. The image formation unit 612Y forms an image with a yellow toner, the image formation unit 612M forms an image with a magenta toner, the image formation unit 612C forms an image with a cyan toner, and the image formation unit 612K forms an image with a black toner. The image formation units 612Y, 612M, 612C and 612K have the same structure as each other except for the difference in the toner color.

The image formation sections 610Y, 610M, 610C and 610K respectively include the optical print heads 611Y, 611M, 611C and 611K as exposure devices for their colors.

Each of the image formation units 612Y, 612M, 612C and 612K includes a photosensitive drum 613 as a rotatably supported image bearing body, a charging roller 614 as a charging member for uniformly charging the surface of the photosensitive drum 613, and a development device 615 for forming a toner image corresponding to an electrostatic latent image by supplying the toner to the surface of the photosensitive drum 613 after the electrostatic latent image is formed on the surface of the photosensitive drum 613 by the exposure by the optical print head 611Y, 611M, 611C, 611K.

The development device 615 includes a toner storage section as a developing agent storage section forming a developing agent storage space for storing the toner, a development roller 616 as a developing agent bearing body for supplying the toner to the surface of the photosensitive drum 613, a supply roller 617 for supplying the toner stored in the toner storage section to the development roller 616, and a development blade 618 as a toner regulation member for regulating the thickness of a toner layer on the surface of the development roller 616.

The exposure by each of the optical print heads 611Y, 611M, 611C and 611K is performed on the uniformly charged surface of the photosensitive drum 613 based on image data for the printing. Each of the optical print heads 611Y, 611M, 611C and 611K includes a light-emitting device array in which a plurality of light-emitting thyristors as a plurality of light-emitting devices are arranged in an axis line direction of the photosensitive drum 613.

As shown in Fig. 28, the conveyance section 630 includes a conveyance belt (transfer belt) 633 electrostatically attracting and conveying the print medium 626, a drive roller 631 rotated by a drive section and driving the conveyance belt 633, a tension roller (driven roller) 632 forming a pair with the drive roller 631 and stretching the conveyance belt 633.

As shown in Fig. 28, the transfer roller 640 is arranged so as to face the photosensitive drum 613 of each image formation unit 612Y, 612M, 612C, 612K across the conveyance belt 633. By the transfer rollers 640, the developing agent images (toner images) formed on the surfaces of the photosensitive drums 613 of the image formation units 612Y, 612M, 612C and 612K are successively transferred to the top surface of the print medium 626 conveyed along the medium conveyance path in the direction of the arrow, by which a color image as a stack of a plurality of toner images is formed. Each image formation unit 612Y, 612M, 612C, 612K includes a cleaning device 619 for removing the toner remaining on the photosensitive drum 613 after the image developed on the photosensitive drum 613 (toner image) is transferred to the print medium 626.

The fixation device 650 includes a pair of rollers 651 and 652 pressed against each other. The roller 651 is a heat roller including a built-in heater, while the roller 652 is a pressure roller pressed against the roller 651. The print medium 626 with the unfixed toner images passes between the pair of rollers 651 and 652 of the fixation device 650. At the time of passage, the unfixed toner images are heated and pressed and thereby fixed on the print medium 626.

(5-2) Operation

First, the print medium 626 in the sheet cassette 621 is drawn out by the hopping roller 622 and is sent to the registration roller 623. Subsequently, the print medium 626 is sent from the registration roller 623 to the conveyance belt 633 via the roller pair 624 and is conveyed to the image formation units 612Y, 612M, 612C and 612K with the traveling of the conveyance belt 633. In the image formation units 612Y, 612M, 612C, 612K, the surface of the photosensitive drum 613 is charged by the charging roller 614 and is exposed by the optical print heads 611Y, 611M, 611C, 611K, by which an electrostatic latent image is formed. The toner formed into a thin layer on the development roller 616 electrostatically adheres to the electrostatic latent image, by which the toner image of each color is formed. The toner images of the colors are transferred onto the print medium 626 by the transfer rollers 640, by which the color toner image is formed on the print medium 626. After the transfer, the toner remaining on the photosensitive drum 613 is removed by the cleaning device 619. The print medium 626 with the color toner image formed thereon is sent to the fixation device 650. In the fixation device 650, the color toner image is fixed on the print medium 626, by which a color image is formed. The print medium 626 with the color image formed thereon is ejected by the ejection roller pair 625 to a sheet stacker.

(5-3) Effect

As described above, in the image forming device 600 in the fifth embodiment, the optical print head 500 in the fourth embodiment is provided as each optical print head 611Y, 611M, 611C, 611K as the exposure device. Thus, according to the image forming device 600 in the fifth embodiment, the quality of printed images can be improved.

**DESCRIPTION OF REFERENCE CHARACTERS**

10 - 14, 20 - 24, 30 - 34: light-emitting thyristor, 41K, 61K: cathode electrode 41K, 41A, 61A: anode electrode, 51G: gate electrode, 71: insulation film, 100, 110, 120, 130, 140, 200, 210, 220, 230, 240, 300, 310, 320, 330, 340: light-emitting device chip, 101: substrate part, 102: substrate, 103: planarization layer, 400: substrate unit, 500: optical print head, 600: image forming device, 1000, 1100, 1200, 1300, 1400, 2000, 2100, 2200, 2300, 2400, 3000, 3100, 3200, 3300, 3400: semiconductor device, 1040, 1140, 1240, 1340, 1440, 2010, 2110, 2210, 2310, 2410, 3040, 3140, 3240, 3340, 3440: first semiconductor layer, 1030, 1130, 1230, 1330, 1430, 2020, 2120, 2220, 2320, 2420, 3030, 3230, 3330, 3430: second semiconductor layer, 1020, 1120, 1220, 1320, 1420, 2030, 2130, 2230, 2330, 2430, 3020, 3120, 3220, 3320, 3420: third semiconductor layer, 1010, 1110, 1210, 1310, 1410, 2040, 2140, 2240, 2340, 3010, 3110, 3210, 3310, 3410: fourth semiconductor layer, 1043, 1143, 1243, 2311, 2411, 3043, 3143, 3243: anode layer (first layer), 1343, 1443, 2011, 2111, 2211, 3343, 3443: cathode layer (first layer), 1042, 1142, 1242, 2312, 2412, 3042, 3142, 3242: electron cladding layer (second layer), 1342, 1442, 2012, 2112, 2212, 3342, 3442: hole cladding layer (second layer), 1041, 1141, 1241, 1341, 1441, 2013, 2113, 2213, 2313, 2413, 3041, 3141, 3241, 3341, 3441: active layer (third layer), 3011, 3111, 3211: cathode layer (fourth layer), 3311, 3411: anode layer (fourth layer), 3012, 3112, 3212: hole cladding layer (fifth layer), 3312, 3412: electron cladding layer (fifth layer), 3013, 3113, 3213, 3313, 3413: active layer (sixth layer).

**Claims**

**1.** A semiconductor device (1000) comprising a light-emitting thyristor (10) including:

a first semiconductor layer (1040) of a first conductivity type;
a second semiconductor layer (1030) of a second conductivity type arranged adjacent to the first semiconductor layer (1040);
a third semiconductor layer (1020) of the first conductivity type arranged adjacent to the second semiconductor layer (1030); and
a fourth semiconductor layer (1010) of the second conductivity type arranged adjacent to the third semiconductor layer (1020),
wherein the first semiconductor layer (1040) includes:

a first layer (1043);

a second layer (1042) having a first band gap wider than a second band gap of the second semiconductor layer (1030) and a third band gap of the third semiconductor layer (1020); and

a third layer (1041) having a first impurity concentration higher than a second impurity concentration of the second semiconductor layer (1030) and a third impurity concentration of the third semiconductor layer (1020), the third layer (1041) having a fourth band gap narrower than or equal to the second band gap of the second semiconductor layer (1030) and the third band gap of the third semiconductor layer (1020).

2. The semiconductor device (1000) according to claim 1, wherein
the second layer (1042) is arranged between the first layer (1043) and the third layer (1041), and
the third layer (1041) is arranged adjacent to the second layer (1042).

3. The semiconductor device (1000) according to claim 1 or 2, wherein
the third layer (1041) is an AlGaAs layer whose Al composition ratio is within a range from 0.14 to 0.18, and
the second semiconductor layer (1030) and the third semiconductor layer (1020) are AlGaAs layers whose Al composition ratios are within a range from 0.14 to 0.3.

4. The semiconductor device (1000) according to any one of claims 1 to 3, wherein the second layer (1042) is a barrier layer that lowers carrier mobility of carriers moving from the second semiconductor layer (1030) towards the second layer (1042) through the third layer (1041).

5. The semiconductor device (1000) according to any one of claims 1 to 4, further comprising:

a first electrode (61A) electrically connected with the first semiconductor layer (1040);
a second electrode (51G) electrically connected with the second semiconductor layer (1030) or the third semiconductor layer (1020); and
a third electrode (41K) electrically connected with the fourth semiconductor layer (1010),
wherein the first layer (1043) electrically connected with the first electrode (61A).

6. The semiconductor device (3000) according to any one of claims 1 to 4, further comprising:

a first electrode (61A) electrically connected with the first semiconductor layer (3040);
a second electrode (51G) electrically connected with the second semiconductor layer (3030) or the third semiconductor layer (3020); and
a third electrode (41K) electrically connected with the fourth semiconductor layer (3010),
wherein the first layer (3043) electrically connected with the first electrode (61A), and
the fourth semiconductor layer (3010) includes:

a fourth layer (3011) electrically connected with the third electrode (41K);
a fifth layer (3012) having a fifth band gap wider than the second band gap of the second semiconductor layer (3030) and the third band gap of the third semiconductor layer (3020); and
a sixth layer (3013) having a fourth impurity concentration higher than the second impurity concentration of the second semiconductor layer (3030) and the third impurity concentration of the third semiconductor layer (3020), the sixth layer (3013) having a sixth band gap narrower than or equal to the second band gap of the second semiconductor layer (3030) and the third band gap of the third semiconductor layer (3020).

7. The semiconductor device (3000) according to claim 6, wherein
the fifth layer (3012) is arranged between the fourth layer (3011) and the sixth layer (3013), and
the sixth layer (3013) is arranged adjacent to the fifth layer (3012).

8. The semiconductor device (3000) according to claim 6 or 7, wherein
the sixth layer (3013) is an AlGaAs layer whose Al composition ratio is within a range from 0.14 to 0.18, and
the second semiconductor layer (3030) and the third semiconductor layer (3020) are AlGaAs layers whose Al composition ratios are within a range from 0.14 to 0.3.

9. The semiconductor device (3000) according to any one of claims 6 to 8, wherein the fifth layer (3012) is a barrier layer that lowers carrier mobility of carriers moving from the third semiconductor layer (3020) towards the fifth layer (3012) through the sixth layer (3013).

**10.** The semiconductor device (1000) according to any one of claims 1 to 9, wherein
the first conductivity type is a P type, and
the second conductivity type is an N type.

**11.** The semiconductor device (1300) according to any one of claims 1 to 9, wherein
the first conductivity type is an N type, and
the second conductivity type is a P type.

**12.** A light-emitting device chip (100) comprising:

a substrate part (101); and
the semiconductor device (1000) according to any one of claims 1 to 11 arranged on the substrate part (101).

**13.** The light-emitting device chip (100) according to claim 12, wherein the first semiconductor layer (1040) is arranged on a side farther from the substrate part (101) than the fourth semiconductor layer (1010).

**14.** The light-emitting device chip (200) according to claim 12, wherein the first semiconductor layer (2010) is arranged on a side closer to the substrate part (101) than the fourth semiconductor layer (2040).

**15.** An optical print head (500) comprising the light-emitting device chip (100) according to any one of claims 12 to 14.

**16.** An image forming device (600) comprising the optical print head (500) according to claim 15.

FIG. 1

LIGHT-EMITTING THYRISTOR 10

EP 3 540 777 A1

# FIG. 2

# FIG. 3

# FIG. 4

# FIG. 5

# FIG. 6

# FIG. 7

# FIG. 8

# FIG. 9

# FIG. 10

# FIG. 11

# FIG. 12

ANODE LAYER

ACTIVE LAYER

CATHODE LAYER

A ← - - - - - - - - - - - B - - - - - - - - - - → C

# FIG. 13

ANODE LAYER

ACTIVE LAYER

CATHODE LAYER

A ← - - - - - - - - - - - B - - - - - - - - - - → C

# FIG. 14

# FIG. 15

# FIG. 16

# FIG. 17

# FIG. 18

# FIG. 19

# FIG. 20

# FIG. 21

# FIG. 22

# FIG. 23

# FIG. 24

# FIG. 25

# FIG. 26

401  104  403  404

402  400

PRINCIPAL PART OF OPTICAL PRINT HEAD
IN FOURTH EMBODIMENT

# FIG. 27

LIGHT

504  404  505  500

506

400

503

501

OPTICAL PRINT HEAD IN FOURTH EMBODIMENT

# FIG. 28

IMAGE FORMING DEVICE IN FIFTH EMBODIMENT

EP 3 540 777 A1

Europäisches
Patentamt
European
Patent Office
Office européen
des brevets

# EUROPEAN SEARCH REPORT

Application Number

EP 18 21 3517

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/219952 A1 (FURUTA HIRONORI [JP] ET AL) 3 August 2017 (2017-08-03) * the whole document * | 1-16 | INV. H01L27/15 B41J2/45 H01L29/74 |
| A | JP 2013 065591 A (FUJI XEROX CO LTD) 11 April 2013 (2013-04-11) * the whole document * | 1-16 | |
| A | JP 2007 180460 A (KYOCERA CORP) 12 July 2007 (2007-07-12) * abstract * | 1-16 | |
| A,D | JP 2010 239084 A (KYOCERA CORP) 21 October 2010 (2010-10-21) * abstract * | 1-16 | |
| A | JP 2015 109417 A (FUJI XEROX CO LTD) 11 June 2015 (2015-06-11) * paragraphs [0004] - [0008], [0013], [0038]; claims 1-9 * | 1-16 | |
| A | WO 2013/191406 A1 (SEOUL VIOSYS CO LTD [KR]) 27 December 2013 (2013-12-27) * claims 1-13 * | 1-16 | TECHNICAL FIELDS SEARCHED (IPC) H01L B41J |

The present search report has been drawn up for all claims

| Place of search | Date of completion of the search | Examiner |
|---|---|---|
| The Hague | 11 April 2019 | But, Gabriela-Ileana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 18 21 3517

This annex lists the patent family members relating to the patent documents cited in the above-mentioned European search report.
The members are as contained in the European Patent Office EDP file on
The European Patent Office is in no way liable for these particulars which are merely given for the purpose of information.

11-04-2019

| Patent document cited in search report | | | Publication date | Patent family member(s) | | | Publication date |
|---|---|---|---|---|---|---|---|
| US 2017219952 | A1 | | 03-08-2017 | JP | 2017135328 | A | 03-08-2017 |
| | | | | US | 2017219952 | A1 | 03-08-2017 |
| JP 2013065591 | A | | 11-04-2013 | JP | 5857569 | B2 | 10-02-2016 |
| | | | | JP | 2013065591 | A | 11-04-2013 |
| JP 2007180460 | A | | 12-07-2007 | JP | 4825005 | B2 | 30-11-2011 |
| | | | | JP | 2007180460 | A | 12-07-2007 |
| JP 2010239084 | A | | 21-10-2010 | JP | 5543124 | B2 | 09-07-2014 |
| | | | | JP | 2010239084 | A | 21-10-2010 |
| JP 2015109417 | A | | 11-06-2015 | JP | 6394210 | B2 | 26-09-2018 |
| | | | | JP | 2015109417 | A | 11-06-2015 |
| WO 2013191406 | A1 | | 27-12-2013 | KR | 20130141945 | A | 27-12-2013 |
| | | | | WO | 2013191406 | A1 | 27-12-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010239084 A